# EUROPÄISCHE PATENTSCHRIFT

(11) **EP 3 502 306 B1**
(45) Veröffentlichungstag und Bekanntmachung des Hinweises auf die Patenterteilung: **02.03.2022**
(21) Anmeldenummer: 17208573.0
(22) Anmeldetag: 19.12.2017
(51) Int. Cl.: C23C 14/20, C08L 69/00

(54) **MEHRSCHICHTKÖRPER, UMFASSEND EINE SUBSTRATSCHICHT ENTHALTEND POLYCARBONAT, TALK UND WACHS**
MULTILAYER BODY, COMPRISING A SUBSTRATE LAYER CONTAINING POLYCARBONATE, TALC AND WAX
CORPS MULTICOUCHE COMPRENANT UNE COUCHE DU SUBSTRAT CONTENANT DU POLYCARBONATE, DU TALC ET DE LA CIRE

(43) Veröffentlichungstag der Anmeldung: 26.06.2019
(73) Patentinhaber: Covestro Deutschland AG, 51373 Leverkusen (DE)
(72) Erfinder: SCHIRWITZ, Christopher, 51375 Leverkussen (DE); ERKELENZ, Michael, 47239 Krefeld (DE); SÄMISCH, Birte, 50670 Köln (DE); PROTTE, Rainer, 41542 Dormagen (DE); DÖBLER, Martin, 40593 Düsseldorf (DE); WENZ, Eckhard, 50937 Köln (DE)
(74) Vertreter: Levpat

(56) Entgegenhaltungen:
- WO-A1-2013/045552
- WO-A1-2013/079398

## Beschreibung

Die vorliegende Erfindung betrifft einen Mehrschichtkörper enthaltend mindestens eine Substratschicht, eine hiermit unmittelbar verbundene Metallschicht und optional eine auf der Metallschicht aufliegende Schutzschicht. Die Substratschicht umfasst eine Zusammensetzung enthaltend Polycarbonat, Talk und ein spezielles Wachs. Des Weiteren betrifft die vorliegende Erfindung Formteile wie Reflektoren sowie (Gehäuse-)Bauteile von Licht- und Wärmequellen, wobei zusätzliche Funktionalität in das Bauteil integriert werden kann, sowie ein Verfahren zur Herstellung eines Mehrschichtkörpers sowie die Verwendung eines speziellen Wachses in der Substratschicht eines Mehrschichtkörpers.

Polycarbonate werden aufgrund ihrer hohen Temperatur- bzw. Wärmeformbeständigkeit u. a. in Bereichen eingesetzt, in denen mit einer erhöhten Temperaturbelastung zu rechnen ist. Auch spezielle Copolycarbonate (beispielsweise Copolycarbonat basierend auf Bisphenol A und Bisphenol TMC (l,l-Bis-(4-hydroxyphenyl)-3,3,5-trimethylcyclohexan)) finden in diesen Bereichen ihren Einsatz, da sie meist eine noch bessere Wärmeformbeständigkeit aufweisen. Polycarbonate eignen sich daher auch zur Herstellung von Linsen, Reflektoren, Lampenabdeckungen und -gehäusen etc., die einer höheren Temperaturbelastung ausgesetzt sind. Bei diesen Anwendungen sind praktisch immer erhöhte thermische Eigenschaften wie die Temperatur- bzw. Wärmeformbeständigkeit in Kombination mit einer verbesserten Wärmeleitfähigkeit und einer guten oder sogar verbesserten Dimensionsstabilität (CLTE, siehe unten) mit ausreichenden mechanischen Eigenschaften wie Schlagzähigkeit zwingend gefordert.

Neben einer guten Verarbeitbarkeit und guten mechanischen Eigenschaften müssen die thermoplastischen Zusammensetzungen auch weiteren Anforderungen wie einer guten Oberflächenqualität im resultierenden Spritzgussteil / Extrudat sowie einer guten Metallisierbarkeit und einer guten Metallhaftung genügen.

Im Bereich der Reflektoranwendungen steht neben der Metallhaftung vielmehr zusätzlich eine geringe Wärmeausdehnung des Substratmaterials und damit auch des Reflektors im Vordergrund. Eine hohe Wärmeausdehnung kann sich nachteilig auf Lichtbündelung und Lichtausbeute auswirken. Der Reflektor ist meist in direkter Umgebung der Lichtquelle, z.B. einer Glühlampe oder einer LED angeordnet, welche häufig eine hohe Wärmeabstrahlung aufweist. Damit ist der Reflektor einer hohen Wärmebelastung - häufig von über 120 °C - ausgesetzt. Aus diesem Grund ist es nötig, ein Substratmaterial mit einem möglichst niedrigen linearen Wäremausdehnungskoeffizienten (coefficient of linear thermal expansion, CLTE) und damit einer guten Dimensionsstabilität einzusetzen. Bevorzugt weist die Metallschicht des Mehrschichtkörpers ein ähnliches Ausdehnungsverhalten und Schwindungsverhalten wie die Substratschicht auf, da es sonst in Folge von Spannungen zu Verwerfungen an der Oberfläche und somit zu Irisierungsphänomenen kommen kann. Oberflächenstörungen wie Rissbildung, Irisierung und Stauchung können so reduziert werden.

Zur Abdeckung von Reflektoren im Automobilbereich sind heute häufig profillose Klarsichtscheiben aus Polycarbonat im Einsatz. Dies erhöht die Anforderungen an die Oberflächengüte der von außen gut sichtbaren Elemente (z. B. Reflektor, Subreflektor, Blendrahmen), wobei die Dimensionsbeständigkeit in der Wärme, ein geringes Ausgasen um Blasenbildung zu vermeiden, die mechanische Festigkeit, eine einfache Verarbeitung und geringe Fertigungstoleranzen weiterhin wichtig sind. Das Material für die Substratschicht sollte sich bevorzugt im Spritzguss mit derartigen Klarsichtscheiben aus Polycarbonat kombinieren lassen.

Wie oben beschrieben müssen entsprechend metallisierte Teile eine hohe Temperaturbeständigkeit/Wärmeformbeständigkeit aufweisen. So dürfen weder die mechanischen Eigenschaften noch die optischen Eigenschaften wie z.B. die Qualität der Metalloberfläche abnehmen.

Um die Materialien, welche die Substratschicht des Mehrschichtkörpers bilden, möglichst kostengünstig zu gestalten, kommen teilweise Füllstoffe zum Einsatz, indem der Thermoplast zum Teil durch preiswertere Füllstoffe ersetzt wird. Je nach gewünschten Eigenschaften, zum Beispiel erhöhtem Flammschutz oder niedrigem Schrumpfverhalten, werden Zusatzstoffe zugesetzt. Jedoch führt die Zugabe von Füllstoffen häufig zu einer rauen, matten oder unregelmäßigen Oberfläche, wodurch die hohen Anforderungen an die Oberflächengüte der (meist gekrümmten) Substratschicht, welche im Anschluss metallisiert wird, nicht erfüllt werden. Speziell bei Reflektoren, bei welchen die Lichtausbeute essentiell ist, muss eine möglichst homogene, sehr glatte, hochglänzende Oberfläche für die Beschichtung bereitgestellt werden.

Talk stellt einen besonders günstigen Füllstoff dar. Zusätzlich zu den bereits oben angesprochenen allgemeinen Problemen bei der Zugabe von Füllstoffen, ist bekannt, dass die Zugabe von Talk zu aufgeschmolzenen Polycarbonaten zu einem Abbau der Polymerketten führt, was sich letztendlich in schlechteren mechanischen Eigenschaften der resultierenden Polycarbonatformkörper niederschlägt.

Dabei ist die Verstärkung von Polycarbonaten durch den Füllstoff Talk auf Grund der Wärmeleitfähigkeit und der günstigen Marktverfügbarkeit von Talk für viele Anwendungen wünschenswert.

Um dennoch Formkörper, umfassend Polycarbonate und Talk, mit ausreichenden mechanischen Eigenschaften zu realisieren, werden für die Herstellung der Formkörper stabilisierte Zusammensetzungen verwendet. Ein Ansatzpunkt stellt hier die vorherige Beschlichtung des Talks dar, wodurch die basischen Gruppen des Talks, welche für die Esterspaltung im Polycarbonat verantwortlich sind, chemisch maskiert werden und somit ein Abbau der Polymerketten im Wesentlichen verhindert werden kann. Eine solche Beschlichtung des Talks stellt jedoch einen zusätzlichen Verfahrensschritt dar, dem der Füllstoff Talk zuvor unterzogen werden muss. Ein solcher zusätzlicher Verfahrensschritt ist immer mit erhöhten Kosten sowie Zeitaufwand verbunden und daher nachteilig. Beispielsweise wird in der WO 2013/124232 A1 Talk als Füllstoff in einem Mehrschichtkörper beschrieben, wobei jedoch eine Beschlichtung bevorzugt ist. Die WO 2013/079398 A1 offenbart ein metallisiertes Substrat basierend auf Polycarbonat und einem Füllstoff.

Aus der JP 08-188708 A sind Zusammensetzungen bekannt, welche 45 bis 97 Gew.-% eines aromatischen Polycarbonats mit 3 bis 55 Gew.-% eines anorganischen Füllstoffes (Glasflocken, Metallflocken, Mica oder Talk) und 0,02 bis 3 Gew.-%, bevorzugt 0,03 bis 1 Gew.-% eines olefinischen Wachses (entsprechen 0,006 bis 3,33 Teile Wachs auf 10 Teile Füllstoff), das carboxylische Gruppen oder Derivate hiervon enthält, enthalten. Auch in diesem Dokument wird darauf verwiesen, dass bei der Verwendung von Talk als Füllstoff ein silanbeschichtetes Material verwendet werden sollte, um einen basischen Abbau des Polycarbonats zu vermeiden. In Beispiel 11 wird eine Zusammensetzung, umfassend 0,05 Teile Wachs auf 10 Teile Talk beschrieben. Allerdings gibt die JP 08-188708 A keinerlei Hinweis darauf, wie der zusätzliche Schritt einer vorherigen Beschlichtung des Füllstoffes vermieden werden kann. Dieses Dokument spricht die resultierende Oberflächengüte des Formkörpers und die Metallhaftung nicht an, so dass ihm keinerlei Einfluss der Verwendung einer Kombination aus Talk und einem speziellen Wachs auf diese Eigenschaften entnommen werden kann.

Die WO 2013/045552 A1 beschreibt eine Polycarbonatzusammensetzung, welche 2 bis 40 Gewichtsteile eines anorganischen Füllstoffes, welcher unter anderem auch Talk sein kann, enthält und 0,01 bis 0,5 Gewichtsteile eines anyhdridmodifizierten alpha-Olefin-Terpolymers.. In einigen Beispielen der WO 2013/045552 A1 wird die Verwendung von 0,5 oder 1,0 Teilen eines Wachses auf 10 Teile Glasfaser oder Quarzmehl beschrieben. Talk wird in den Beispielen nicht verwendet. Dieses Dokument spricht die spezielle Problematik des Abbaus des Polycarbonats durch die Verwendung von Talk nicht an. Auch kann der Fachmann diesem Dokument keine Lehre in Bezug auf die Verbesserung der Oberflächenqualität (und/oder Oberflächenrauigkeit), Metallhaftung oder CLTE entnehmen.

Ausgehend von diesem Stand der Technik lag der vorliegenden Erfindung die Aufgabe zu Grunde, einen Mehrschichtkörper bereitzustellen, welcher über eine gute Temperatur- bzw. Wärmeformbeständigkeit, verbesserte Dimensionsstabilität, bevorzugt einen geringen linearen Wärmeausdehnungskoeffizienten (coefficient of linear thermal expansion = CLTE) von < 50ppm/K bezogen auf die parallele thermische Ausdehnung und < 60 ppm/K bezogen auf die transverse thermische Ausdehnung nach DIN 53752 (1980-12) und eine verbesserte Oberflächenqualität in Kombination mit guten mechanischen Eigenschaften verfügt. Weiterhin weisen die Mehrschichtformkörper eine verbesserte Wärmeleitfähigkeit auf.

Gleichzeitig soll die Substratschicht des Mehrschichtkörpers möglichst günstig herzustellen sein. Insbesondere lag der vorliegenden Erfindung die Aufgabe zu Grunde, eine Substratschicht für einen Mehrschichtkörper bereitzustellen, welche gleichzeitig über eine gute Dimensionsstabilität bei Erwärmen (CLTE), verbesserte Oberflächenqualität und Metallhaftung verfügt und somit eine ausgewogene Balance dieser Eigenschaften aufweist. Die Substratschicht ist somit insbesondere geeignet für die Herstellung von Mehrschichtkörpern, umfassend zusätzlich mindestens eine Metallschicht, welche erhöhten Temperaturbelastungen ausgesetzt ist. Dabei soll die Zusammensetzung für die Substratschicht zusätzlich ein gutes Eigenschaftsprofil in Bezug auf gute Fließfähigkeit (Scherviskositätsverlauf) und gute mechanische Eigenschaften (E-Modul und Charpy) aufweisen.

Gelöst wurden diese Aufgaben durch die Bereitstellung des erfindungsgemäßen Mehrschichtenkörpers, des erfindungsgemäßen Verfahrens, der erfindungsgemäßen Formteile wie Reflektoren und (Gehäuse-)Bauteile von Licht - und Wärmequellen sowie der erfindungsgemäßen Verwendung, welche alle im Folgenden näher erläutert werden.

Es wurde überraschenderweise gefunden, dass Mehrschichtkörper enthaltend eine Substratschicht, enthaltend eine Kombination aus Talk als Füllstoff mit einem speziellen Wachs und Polycarbonat als Thermoplast (im Folgenden als Substratmaterial bezeichnet), das gewünschte Eigenschaftsprofil aus geringer Wärmeausdehnung und guten mechanischen Eigenschaften aufweisen. Gleichzeitig weisen sie eine verbesserte Oberflächenqualität, insbesondere nach variothermem Erhitzen, und gute, bevorzugt verbesserte Metallhaftung auf. Insgesamt weisen die verwendeten Zusammensetzungen eine gute Verarbeitbarkeit und die erfindungsgemäßen Mehrschichtkörper gute mechanische Eigenschaften auf.

Überraschend wurde zudem gefunden, dass die Mehrschichtkörper zudem eine deutlich verbesserte Wärmeleitfähigkeit aufweisen, die für die Verwendung in Formteilen wie Reflektoren und (Gehäuse-)B auteilen von Lichtquellen eine zusätzliche verbesserte Verteilung und Ableitung der Wärmelast bewirkt.

Es wurde weiterhin gefunden, dass sogar unbeschlichteter Talk im Substratmaterial der erfindungsgemäßen Mehrschichtenkörpern verwendet werden kann. Durch die Vermischung eines speziellen Wachses, welches eine spezielle Säurezahl und ein spezielles Molekulargewicht aufweist, mit einem unbeschlichteten Talk, insbesondere einem Talk mit einem alkalischen pH-Wert bevorzugt von 8 bis 10, ab dem Zeitpunkt der Zugabe des Talks als Füllstoff zur Polycarbonatschmelze eine Beschlichtung erzielt werden kann, die ausreichend ist, um den Abbau ("Degradation") der Estergruppen des Polycarbonats zu reduzieren. Dies bedeutet, dass ein unbeschlichteter Talk, worunter auch ein Talkgemisch verstanden wird, B) ohne Vorbehandlung direkt zu Polycarbonat A) gegeben werden kann, wenn gleichzeitig ein anhydridmodifiziertes alpha-Olefin-Polymer C) zugegeben wird. Obwohl der Talk unbeschlichtet ist, findet bei der Vermischung der Komponenten A) bis D) eine ausreichende Anlagerung des Wachses C) an der Oberfläche des Talks B) statt ("in-situ Beschlichtung"). Die Aufgabe wird somit weiterhin gelöst durch die Verwendung von anhydridmodifiziertem alpha-Olefin-Polymer mit einer Säurezahl, bestimmt mittels potentiometrischer Titration mit alkoholischer Kaliumhydroxid-Lösung gemäß DIN ISO 17025:2005, von mindestens 30 mg KOH/g und einem mittleren Molekulargewicht MW von 4.000 bis 40.000 g/mol, wobei das mittlere Molekulargewicht MW bestimmt wird mittels Gelpermeationschromatographie in ortho-Dichlorbenzol bei 150 °C mit Polystyrolkalibrierung, zur Stabilisierung von Polycarbonat in einer Zusammensetzung, der unbeschlichteter Talk zugesetzt wird,
wobei pro 10 Gewichtsteile des unbeschlichteten Talks 0,10 bis 1,4 Gewichtsteile, bevorzugt 0,3 bis 1,0 Gewichtsteile des anhydridmodifizierten alpha-Olefin-Polymers eingesetzt werden. Bevorzugt enthält die Zusammensetzung keinen Polyester und kein Pfropfpolymerisat, ganz besonders bevorzugt überhaupt keinen Impact Modifier (Schlagzähmodifikator) außer dem teilweise in der Literatur als Impact Modifier bezeichneten anhydridmodifizierte alpha-Olefin-Polymer gemäß Komponente C). Das Substratmaterial zeichnet sich dadurch aus, dass auf diese Weise die Eigenschaften wie gute Verarbeitbarkeit, hohe Steifigkeit und gute Schlagzähigkeit der Polycarbonat/Talk-Zusammensetzungen beibehalten, gegenüber dem Stand der Technik sogar auch verbessert werden können. Dadurch ist es möglich, den zusätzlichen Schritt der Vorbehandlung des Talks bzw. des Talkgemisches B) mit einer Schlichte zu vermeiden und somit eine kostengünstiger und effizienter herzustellende Zusammensetzung bereitzustellen.

Erfindungsgemäß ist es insbesondere überraschend, dass trotz Zugabe des Wachses und Talks zum Polycarbonat die Metallhaftung der Substratschicht nicht verschlechtert wird. Polycarbonat als Homopolymer weist insgesamt bereits eine sehr gute Metallhaftung auf. Daher war es überraschend, dass die Zugabe der Komponenten B) und C) nur geringe Auswirkungen auf diese Eigenschaften aufweist.

Gleichzeitig ist es ebenso überraschend, dass die Zugabe des Wachses zu hochwärmeformbeständigen Copolycarbonaten, wie beispielsweise Copolycarbonat basierend auf Bisphenol A und Bisphenol TMC, ebenfalls zu guten Resultaten in Bezug auf die Eigenschaften der Substratschicht führt. Da die Zugabe der speziellen Wachse die Temperatur- bzw. Wärmeformbeständigkeit dieser Copolycarbonate in der Regel herabsetzen würde, würde der Fachmann die entsprechende Zugabe für Substratschichten eines Mehrschichtkörpers nicht in Betracht ziehen. Es konnten aber insgesamt gute Eigenschaftsprofile erhalten werden, in denen weiterhin gute Temperatur- bzw. Wärmeformbeständigkeit, gute Dimensionsstabilität bei Erwärmen (CLTE), verbesserte Oberflächenqualität, gute, bevorzugt verbesserte Metallhaftung bei gleichzeitig guten mechanischen Eigenschaften erzielt wurden. Damit sind die so erhaltenen Substratschicht auch unter Verwendung von Copolycarbonaten, insbesondere von Copolycarbonaten, umfassend Bisphenol TMC, gut geeignet für die hier beschriebenen Mehrschichtkörper.

Trotz der bekannten Anisotropie des CLTE von Talkum-haltigen thermoplastischen Formmassen können die in der vorliegenden Erfindung beschriebenen Mehrschichtkörper für hochpräzise Bauteile von Leuchten wie Reflektoren und anderen optischen Elementen verwendet werden, da die thermische Ausdehnung auf ein insgesamt niedriges Niveau abgesenkt wird und die Mehrschichtkörper eine hohe Oberflächenqualität aufweisen.

Gegenstand der vorliegenden Erfindung ist daher ein Mehrschichtkörper, welcher
I) eine Substratschicht (S),
II) eine hiermit unmittelbar verbundene Metallschicht (M) und
III) gegebenenfalls eine auf der Metallschicht aufliegende Schutzschicht (P) umfasst,
wobei die Substratschicht eine Zusammensetzung umfasst, erhältlich durch Vermischen der Komponenten A) bis D), wobei
A) ein Polycarbonat ist,
B) ein unbeschlichteter Talk mit einem mittleren Partikeldurchmesser D50 von 0,01 bis 9,5 µm ist, wobei der Partikeldurchmesser D50 bestimmt wird durch Sedimentationsanalyse,
C) mindestens ein anhydridmodifiziertes alpha-Olefin-Polymer ist mit einer Säurezahl von mindestens 30 mg KOH/g, bestimmt mittels potentiometrischer Titration mit alkoholischer Kaliumhydroxid-Lösung gemäß DIN ISO 17025:2005, und einem mittleren Molekulargewicht MW von 4.000 bis 40.000 g/mol ist, wobei das mittlere Molekulargewicht MW bestimmt wird mittels Gelpermeationschromatographie in ortho-Dichlorbenzol bei 150 °C mit Polystyrolkalibrierung,
   sowie
   optional D) ein Teil der Menge an Komponente B) durch mindestens einen weiteren Füllstoff ausgewählt aus der Gruppe bestehend aus
      a) einem expandierten Graphit mit einem Teilchendurchmesser D50 von kleiner 800µm,
      b) eine Mischung aus dem vorgenannten expandiertem Graphit mit nicht expandiertem Graphit,
      c) eine Mischung aus dem vorgenannten expandiertem Graphit mit nicht expandiertem Graphit und Bornitrid
      d) eine Mischung aus dem vorgenannten expandiertem Graphit und Bornitrid
      als weiterer Füllstoff ersetzt werden kann, wobei im Falle des Graphits bis zu 8 Gew.-Teile der Menge an Komponente B) ersetzt werden können und wobei im Falle des Bornitrids bis zu 15 Gew.-Teile der Menge an Komponente B) ersetzt werden können.
   wobei die Mengen der Komponenten B) und C) vor der Vermischung mit Komponente C) so aufeinander abgestimmt sind, dass pro 10 Gewichtsteile der Komponente B) 0,10 bis 1,4 Gewichtsteile der Komponente C) eingesetzt werden und wobei die Zusammensetzung frei ist von Pfropfpolymerisaten und Polyestern, Die Komponente C) im Sinne der vorliegenden Erfindung ist kein "impact modifier" wie sie in der Literaur teilweise bezeichnet wird.

Die Schichten I) und II) sind unmittelbar verbunden. Es liegt daher keine weitere Schicht zwischen den Schichten I) und II) Dies schließt jedoch nicht aus, dass die Schicht I vor der Metallisierung plasmavorbehandelt wird.

Im Sinne der vorliegenden Erfindung wird unter dem Begriff "Vermischung"/"vermischen" bevorzugt das "miteinander in Kontakt Bringen" der Komponenten A) bis D) verstanden. Bevorzugt werden dazu mechanische Hilfsmittel verwendet. Die Vermischung findet bei Temperaturen statt, in denen die Komponente A) zumindest teilweise aufgeschmolzen ist. Bevorzugt findet die Vermischung bei Temperaturen im Bereich von 250 °C bis 350 °C statt. Besonders bevorzugt sind Temperaturen von 260 °C bis 310 °C für im Wesentlichen Bisphenol A basierte Polycarbonate. "Im Wesentlichen" bedeutet hierbei einen Anteil von bevorzugt mindestens 90 Gew.-%, weiter bevorzugt mindestens 95 Gew.-%, ganz besonders bevorzugt mindestens 98 Gew.-% Bisphenol A, bezogen auf die Gesamtmenge an eingesetzten Diphenolen. Für Copolycarbonate mit beispielsweise Diphenolen, ausgewählt aus 1,1-Bis-(4-hydroxyphenyl)-3,3,5-trimethylcyclohexan, Diphenolen der nachfolgend dargestellten Formeln (I), (II) und/oder (III) und/oder siloxanhaltigen Copolycarbonaten liegen die Temperaturen vorzugsweise im Bereich von 280 °C bis 350 °C. Die Vermischung kann auf üblichen Compoundieraggregaten durchgeführt werden. Bevorzugt sind Schneckenextruder, Ringextruder oder (Ko-)Kneter.

### Substratschicht I

### Komponente A)

Bei Komponente A) handelt es sich um mindestens ein Polycarbonat. Als Komponente A) können somit auch Mischungen eingesetzt werden. Polycarbonate im Sinne der vorliegenden Erfindung sind sowohl Homopolycarbonate als auch Copolycarbonate; die Polycarbonate können in bekannter Weise linear oder verzweigt sein. Bevorzugt handelt es sich bei dem mindestens einen Polycarbonat um ein aromatisches Polycarbonat. Unter Copolycarbonaten werden auch siloxanhaltige Polycarbonate verstanden.

Die Herstellung der Polycarbonate erfolgt in bekannter Weise aus Diphenolen, Kohlensäurederivaten, gegebenenfalls Kettenabbrechern und Verzweigern. Im Fall der Homopolycarbonate wird nur ein Diphenol eingesetzt, im Fall der Copolycarbonate werden mehrere Diphenole eingesetzt. Ebenso können zur Herstellung der erfindungsgemäßen Copolycarbonate 1 bis 25 Gew.%, vorzugsweise 2,5 bis 25 Gew.%, bezogen auf die Gesamtmenge an einzusetzenden Diphenolen, Polydiorganosiloxane mit Hydroxyaryloxy-Endgruppen eingesetzt werden. Diese sind bekannt (z. B. US 3 419 634 A) und nach literaturbekannten Verfahren herstellbar. Ebenfalls geeignet sind polydiorganosiloxanhaltige Copolycarbonate; die Herstellung der polydiorganosiloxanhaltiger Copolycarbonate ist beispielsweise in der DE-A 3 334 782 beschrieben.

Die Herstellung von Polycarbonaten erfolgt z.B. durch Umsetzung von Diphenolen mit Kohlensäurehalogeniden, vorzugsweise Phosgen, und/oder mit Dicarbonsäuredihalogeniden, vorzugsweise aromatischen Dicarbonsäuredihalogeniden, vorzugsweise Benzoldicarbonsäuredihalogeniden, nach dem Phasengrenzflächenverfahren, gegebenenfalls unter Verwendung von Kettenabbrechern und gegebenenfalls unter Verwendung von trifunktionellen oder mehr als trifunktionellen Verzweigern. Ebenso ist eine Herstellung über ein Schmelzepolymerisationsverfahren durch Umsetzung von Diphenolen mit beispielsweise Diphenylcarbonat möglich.

Für die Herstellung der Polycarbonate geeignete Diphenole sind beispielsweise Hydrochinon, Resorcin, Dihydroxydiphenyle, Bis-(hydroxyphenyl)-alkane, Bis-(hydroxyphenyl)-cycloalkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, α-α'-Bis-(hydroxyphenyl)-diisopropylbenzole, Phtalimidine abgeleitet von Isatin- oder Phenolphthaleinderivaten sowie deren kernalkylierte, kernarylierte und kernhalogenierte Verbindungen.

Bevorzugte Diphenole sind ausgewählt aus mindestens einem aus der Gruppe 4,4'-Dihydroxydiphenyl, 2,2-Bis-(4-hydroxyphenyl)-propan (Bisphenol A), 2,4-Bis-(4-hydroxyphenyl)-2-methylbutan, 1,1-Bis-(4-hydroxyphenyl)-p-diisopropylbenzol, 2,2-Bis-(3-methyl-4-hydroxyphenyl)-propan, Dimethyl-Bisphenol A, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,1-Bis-(3,5-dimethyl-4-hydroxyphenyl)-p-diisopropylbenzol, und 1,1-Bis-(4-hydroxyphenyl)-3,3,5-trimethylcyclohexan, sowie den Diphenolen (I) bis (III) 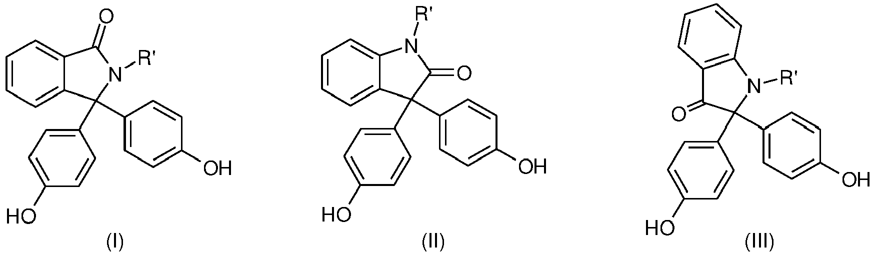 in denen R' jeweils für C₁- bis C₄-Alkyl, Aralkyl oder Aryl, bevorzugt für Methyl oder Phenyl, ganz besonders bevorzugt für Methyl, steht.

Besonders bevorzugte Diphenole sind ausgewählt aus mindestens einem aus der Gruppe bestehend aus 2,2-Bis-(4-hydroxyphenyl)-propan (Bisphenol A), 2,2-Bis-(3,5-dimethyl-4-hydroxyphenyl)-propan, 1,1-Bis-(4-hydroxyphenyl)-cyclohexan, 1,1-Bis-(4-hydroxyphenyl)-3,3,5-trimethylcyclohexan, Dimethyl-Bisphenol A sowie den Diphenolen der Formeln (I), (II) und/oder (III).

Diese und weitere geeignete Diphenole sind z.B. in US-A 3 028 635, US-A 2 999 825, US-A 3 148 172, US-A 2 991 273, US-A 3 271 367, US-A 4 982 014 und US-A 2 999 846, in DE-A 1 570 703, DE-A 2063 050, DE-A 2 036 052, DE-A 2 211 956 und DE-A 3 832 396, in FR-A 1 561 518, in der Monographie "H. Schnell, Chemistry and Physics of Polycarbonates, Interscience Publishers, New York 1964" sowie in JP-A 62039/1986, JP-A 62040/1986 und JP-A 105550/1986 beschrieben.

Geeignete Kohlensäurederivate sind beispielsweise Phosgen oder Diphenylcarbonat.

Geeignete Kettenabbrecher, die bei der Herstellung der erfindungsgemäß verwendeten Polycarbonate eingesetzt werden können, sind Monophenole. Geeignete Monophenole sind beispielsweise Phenol selbst, Alkylphenole wie Kresole, p-tert.-Butylphenol, Cumylphenol, sowie deren Mischungen.

Bevorzugte Kettenabbrecher sind die Phenole, welche ein- oder mehrfach mit C₁- bis C₃₀-Alkylresten, linear oder verzweigt, bevorzugt unsubstituiert, oder mit tert-Butyl substituiert sind. Besonders bevorzugte Kettenabbrecher sind Phenol, Cumylphenol und/oder p-tert-Butylphenol.

Die Menge an einzusetzendem Kettenabbrecher beträgt bevorzugt 0,1 bis 5 Mol-%, bezogen auf Mole an jeweils eingesetzten Diphenolen. Die Zugabe der Kettenabbrecher kann vor, während oder nach der Umsetzung mit einem Kohlensäurederivat erfolgen.

Geeignete Verzweiger sind die in der Polycarbonatchemie bekannten tri- oder mehr als trifunktionellen Verbindungen, insbesondere solche mit drei oder mehr als drei phenolischen OH-Gruppen.

Geeignete Verzweiger sind beispielsweise 1,3,5-Tri-(4-hydroxyphenyl)-benzol, 1,1,1-Tri-(4-hydroxyphenyl)-ethan, Tri-(4-hydroxyphenyl)-phenylmethan, 2,4-Bis-(4-hydroxyphenylisopropyl)-phenol, 2,6-Bis-(2-hydroxy-5'-methyl-benzyl)-4-methylphenol, 2-(4-Hydroxyphenyl)-2-(2,4-dihydroxyphenyl)-propan, Tetra-(4-hydroxyphenyl)-methan, Tetra-(4-(4-hydroxyphenylisopropyl)-phenoxy)-methan und 1,4-Bis-((4',4"-dihydroxytriphenyl)-methyl)-benzol und 3,3-Bis-(3-methyl-4-hydroxyphenyl)-2-oxo-2,3-dihydroindol.

Die Menge der gegebenenfalls einzusetzenden Verzweiger beträgt bevorzugt 0,05 Mol-% bis 2,00 Mol-%, bezogen auf Mole an jeweils eingesetzten Diphenolen.

Die Verzweiger können entweder mit den Diphenolen und den Kettenabbrechern in der wässrig alkalischen Phase vorgelegt werden oder in einem organischen Lösungsmittel gelöst vor der Phosgenierung zugegeben werden. Im Fall des Umesterungsverfahrens werden die Verzweiger zusammen mit den Diphenolen eingesetzt.

Bevorzugte Herstellungsweisen der erfindungsgemäß zu verwendenden Polycarbonate, einschließlich der Polyestercarbonate, sind das bekannte Grenzflächenverfahren und das bekannte Schmelzumesterungsverfahren (vgl. z. B. WO 2004/063249 A1, WO 2001/05866 A1, WO 2000/105867, US-A 5,340,905, US-A 5,097,002, US-A 5,717,057).

Im ersten Fall dienen als Säurederivate vorzugsweise Phosgen und gegebenenfalls Dicarbonsäuredichloride, im letzteren Fall vorzugsweise Diphenylcarbonat und gegebenenfalls Dicarbonsäurediester. Katalysatoren, Lösungsmittel, Aufarbeitung, Reaktionsbedingungen etc. für die Polycarbonatherstellung bzw. Polyestercarbonatherstellung sind in beiden Fällen hinreichend beschrieben und bekannt.

Besonders bevorzugte Polycarbonate sind das Homopolycarbonat auf Basis von Bisphenol A, das Homopolycarbonat auf Basis von 1,1-Bis-(4-hydroxyphenyl)-3,3,5-trimethylcyclohexan sowie Copolycarbonate auf Basis der beiden Monomere Bisphenol A und 1,1-Bis-(4-hydroxyphenyl)-3,3,5-trimethylcyclohexan. Ebenso bevorzugt sind siloxanhaltige Polycarbonate wie oben beschrieben, besonders bevorzugt aus Dimethylsiloxanen mit Bisphenol A als Monomerbausteine.

Die thermoplastischen Polycarbonate einschließlich der thermoplastischen, aromatischen Polyestercarbonate haben bevorzugt mittlere Molekulargewichte Mw, bestimmt mittels Gelpermeationschromotographie, von 15.000 g/mol bis 40.000 g/mol, weiter bevorzugt von 18.000 g/mol bis 33.000 g/mol, besonders bevorzugt von 22.000 g/mol bis 32.000 g/mol, ganz besonders bevorzugt von 23.000 bis 25.000 g/mol. Die Kalibrierung erfolgt mit linearen Polycarbonaten (aus Bisphenol A und Phosgen) bekannter Molmassenverteilung der PSS Polymer Standards Service GmbH, Deutschland, Kalibrierung nach der Methode 2301-0257502-09D (aus dem Jahre 2009 in deutscher Sprache) der Currenta GmbH & Co. OHG, Leverkusen. Das Elutionsmittel ist Dichlormethan. Säulenkombination aus vernetzten Styrol-Divinylbenzolharzen. Durchmesser der analytischen Säulen: 7,5 mm; Länge: 300 mm. Partikelgrößen des Säulen-materials: 3 µm bis 20 µm. Konzentration der Lösungen: 0,2 Gew.-%. Flussrate: 1,0 ml/min, Temperatur der Lösungen: 30°C. Detektion mit Hilfe eines Brechungsindex(RI)- Detektors.

Die thermoplastischen Polycarbonate weisen im Allgemeinen einen MVR (Schmelzvolumenflussrate) von 2-40 cm³/10min, bevorzugt 3-38 cm³/10, besonders bevorzugt 5-36 cm³/10min bestimmt nach ISO 1133-1:2012-03 (300°C, 1,2 kg) auf.

Die **Siloxan-haltigen Polycarbonate** (im Folgenden auch als SiCoPC bezeichnet) betreffen Blockcokondensate mit folgenden Struktureinheiten: 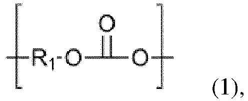
wobei R1 ein divalenter substituierter oder unsubstituierter aromatischer Rest, ein divalenter linearer oder cyclischer aliphatischer Rest ist
oder die Struktureinheit (1) eine Mischung aus Bausteinen ist, wobei R1 ein divalenter substituierter oder unsubstituierter aromatischer Rest bzw. R1 ein divalenter linearer oder cyclischer aliphatischer Rest ist. Der Anteil an aromatischen R1-Resten beträgt bevorzugt
60 - 100 Gew.-% und der Anteil an aliphatischen Resten 0 - 40 Gew.-%, bezogen auf die Summe der eingesetzten Diphenole der Formel (3) in Gew.-%
   und 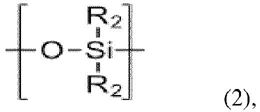
wobei R2 unabhängig voneinander ein linearer oder verzweigter aliphatischer Rest, bevorzugt C₁- bis C₁₂-Alkyl, besonders bevorzugt C₁- bis C₄-Alkyl, insbesondere Methyl, oder ein substituierter oder unsubstituierter aromatischer Rest, bevorzugt Phenyl, ist.

Ganz besonders bevorzugte Struktureinheiten (2) sind Dimethylsiloxan-, oder Diphenylsiloxan-, Methyl/Phenylsiloxan- oder Mischungen aus Dimethylsiloxan- und Diphenylsiloxaneinheiten.

In der Struktureinheit (1) ist R1 bevorzugt von Dihydroxyarylverbindungen abgeleitet, welche der Formel (3) entsprechen:

HO-Z-OH (3),

in welcher
Z ein aromatischer Rest mit 6 bis 30 C-Atomen ist, der einen oder mehrere aromatische Kerne enthalten kann, substituiert sein kann und aliphatische Reste bzw. Alkylaryle oder Heteroatome als Brückenglieder enthalten kann.

Bevorzugt steht Z in Formel (3) für einen Rest der Formel (3a) 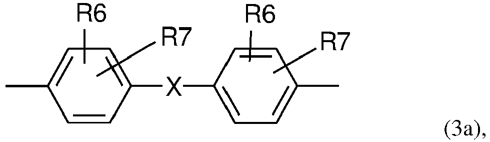 in der
R6 und R7 unabhängig voneinander für H, C₁- bis C₁₈-Alkyl, C₁- bis C₁₈-Alkoxy, Halogen wie Cl oder Br oder für jeweils gegebenenfalls substituiertes Aryl- oder Aralkyl, bevorzugt unabhängig voneinander für H oder C₁- bis C₁₂-Alkyl, besonders bevorzugt für H oder C₁-bis C₈-Alkyl und ganz besonders bevorzugt unabhängig voneinander für H oder Methyl stehen, und
X für -CO- , -O- , -S-, C₁- bis C₆-Alkylen, C₂- bis C₅-Alkyliden, C₆- bis C₁₀-Cycloalkyliden oder für C₆- bis C₁₂-Arylen, welches gegebenenfalls mit weiteren Heteroatome enthaltenden aromatischen Ringen kondensiert sein kann, steht.

Bevorzugt steht X für C₁- bis C₅-Alkylen, C₂- bis C₅-Alkyliden, C₆- bis C₉-Cyclohexyliden, -O- , -SO- , -CO- , -S- , -SO₂-, besonders bevorzugt für Isopropyliden, 3,3,5-Trimethylcyclohexyliden oder -O-, insbesondere für Isopropyliden.

Für die Herstellung der erfindungsgemäßen SiCoPCs geeignete Diphenole der Formel (3) sind beispielsweise Hydrochinon, Resorcin, Bis-(hydroxyphenyl)-alkane, Bis-(hydroxyphenyl)-sulfide, Bis-(hydroxyphenyl)-ether, Bis-(hydroxyphenyl)-ketone, Bis-(hydroxyphenyl)-sulfone, Bis-(hydroxyphenyl)-sulfoxide, [alpha],[alpha]'-Bis-(hydroxyphenyl)-diisopropylbenzole sowie deren alkylierte, kernalkylierte und kernhalogenierte Verbindungen.

Ferner bevorzugte Diphenole der Formel (3) sind 4,4'-Dihydroxydiphenyl, 2,2-Bis-(4-hydroxyphenyl)-1-phenyl-propan, 1,1-Bis-(4-hydroxyphenyl)-phenyl-ethan, 2,2-Bis-(4-hydroxyphenyl)propan, 2,2-Bis-(3-methyl-4-hydroxyphenyl)-propan, 2,4-Bis-(4-hydroxyphenyl)-2-methylbutan, 1,3-Bis-[2-(4-hydroxyphenyl)-2-propyl]benzol (Bisphenol M), 2,2-Bis-(3-methyl-4-hydroxyphenyl)-propan, Bis-(3,5-dimethyl-4-hydroxyphenyl)-methan, 2,2-Bis-(3,5-dimethyl-4-hydroxyphenyl)-propan, Bis-(3,5-dimethyl-4-hydroxyphenyl)-sulfon, 2,4-Bis-(3,5-dimethyl-4-hydroxyphenyl)-2-methylbutan, 1,3-Bis-[2-(3,5-dimethyl-4-hydroxyphenyl)-2-propyl]-benzol, 1,1-Bis-(4-hydroxyphenyl)-cyclohexan und 1,1-Bis-(4-hydroxyphenyl)-3,3,5-trimethylcyclohexan.

Besonders bevorzugte Diphenole der Formel (3) sind 2,2-Bis-(4-hydroxyphenyl)-propan (BPA), Hydrochinon, 1,1-Bis-(4-hydroxyphenyl)-3,3,5-trimethylcyclohexan und 2,2-Bis-(3-methyl, 4-hydroxyphenyl)-propan.

Diese und weitere geeignete Diphenole sind kommerziell erhältlich und z. B. in "H. Schnell, Chemistry and Physics of Polycarbonates, Interscience Publishers, New York 1964, S. 28 ff; S. 102 ff" , und in "D. G. Legrand, J. T. Bendler, Handbook of Polycarbonate Science and Technology, Marcel Dekker New York 2000, S. 72 ff." beschrieben.

In einer Ausführungsform kann der Siloxanblock folgende Struktur (4) haben 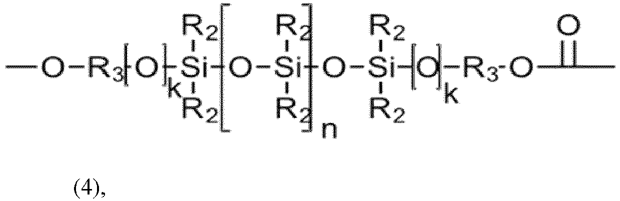
wobei R2 die oben genannte Bedeutung hat,
n eine durchschnittliche Zahl von 10 bis 400, bevorzugt 10 bis 100, besonders bevorzugt 15 bis 50, ist
und k für 0 oder 1 steht.
R3 umfasst unabhängig voneinander folgende Strukturelemente (5) oder (6) 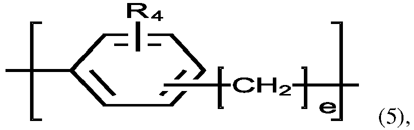
wobei R4 unabhängig voneinander Wasserstoff, Halogen und/oder jeweils ein C₁- bis C₁₀-, bevorzugt ein C₁- bis C₄-, linearer oder verzweigter, unsubstituierter oder ein- bis vierfach substituierter Alkylrest oder Alkoxyrest ist, bevorzugt sind die Alkyl- und Alkoxyreste unsubstituiert, insbesondere bevorzugt ist R4 Wasserstoff,
e 0 oder eine natürliche Zahl von 2 bis 12, bevorzugt 2 bis 6, ist, wobei im Falle, dass e gleich 0 ist, k gleich 1 ist;
oder Strukturelement der Formel (6) 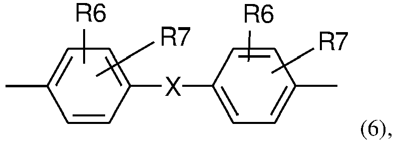
wobei R6, R7 und X die bei Formel (3a) angegebenen Bedeutungen haben.

Beispielsweise und bevorzugt kann der Siloxanblock folgende Strukturen umfassen: 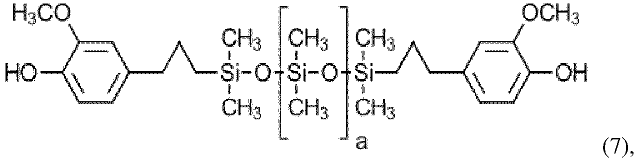 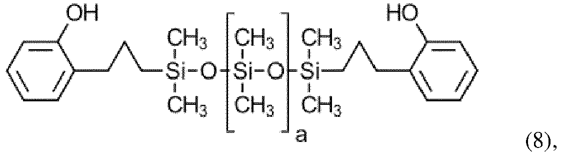 wobei a in den Formeln (7) und (8) für eine durchschnittliche Zahl von 10 bis 400, bevorzugt 10 bis 100 und besonders bevorzugt für 15 bis 50, steht.

In einer weiteren Ausführungsform können die oben genannten Siloxanblöcke einfach oder mehrfach über Terephthalsäure oder Isophthalsäure verknüpft sein zu folgenden beispielhaft gezeigten Strukturelementen: 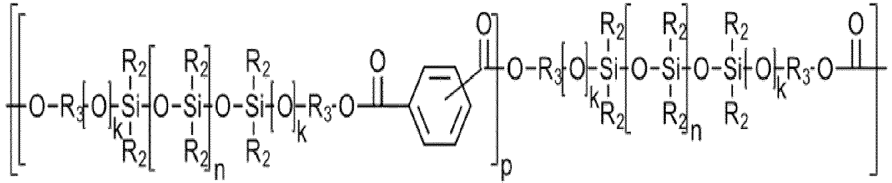
wobei p für 0 oder 1 steht,
R2, R3, n und k die oben bei dem Strukturelement (4) angegebenen Bedeutungen haben.

Entsprechende Siloxanblöcke zur Umsetzung mit Polycarbonat oder zur Umsetzung mit Diphenolen der Formel (3) oder (3a) mit Phosgen oder Diarylcarbonaten weisen jeweils terminal phenolische OH Gruppen auf, d.h. 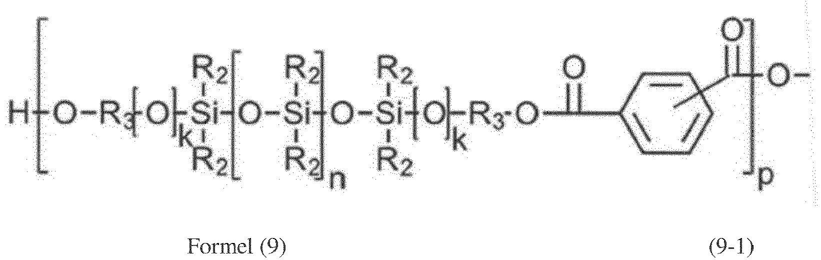 die Formel wird am Sauerstoffatom -R3 weitergeführt: 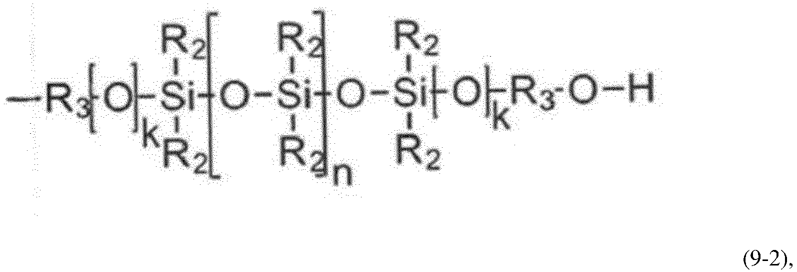 aufgrund der Länge der Formel wurde die Formel (9) geteilt: Formel (9-2) ist die Fortsetzung von Formel (9-1)
wobei R2, R3, n, k und p die bei dem Strukturelement (9) angegebenen Bedeutungen haben.

Bevorzugte Siloxanblöcke sind Hydroxyaryl-terminiertes Polysiloxan und entsprechen der Formel (10)

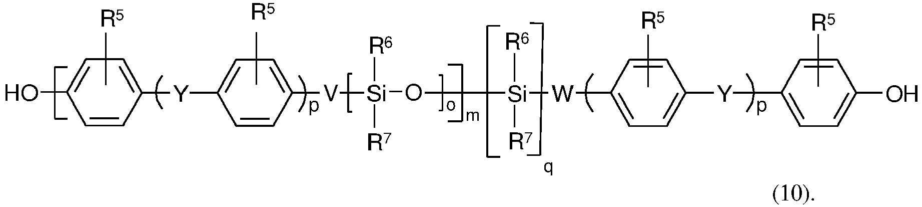

In der allgemeinen Formel (10) steht R5 für Wasserstoff oder C1- bis C4-Alkyl, C1- bis C4-Alkoxy, vorzugsweise für Wasserstoff oder Methyl, Methyloxy, besonders bevorzugt für Wasserstoff.

R⁶ und R⁷ stehen unabhängig voneinander für Aryl, bevorzugt Phenyl, C₁- bis C₄-Alkyl, vorzugsweise für Methyl, insbesondere für Methyl.

Y steht für eine Einfachbindung, -CO-, -O-, C₁- bis C₅-Alkylen, C₂- bis C₅-Alkyliden oder für einen C₅- bis C₆-Cycloalkylidenrest, der ein- oder mehrfach mit C₁- bis C₄-Alkyl substituiert sein kann, bevorzugt für eine Einfachbindung, -O-, Isopropyliden oder für einen C₅- bis C₆-Cycloalkylidenrest, der ein- oder mehrfach mit C₁- bis C₄-Alkyl substituiert sein kann, und insbesondere für Isopropyliden.

V steht für Sauerstoff, C₁- bis C₆-Alkylen oder C₂- bis C₅-Alkyliden, bevorzugt für eine Einfachbindung, Sauerstoff, C₃-Alkylen, insbesondere Sauerstoff oder Isopropyliden.

W steht für eine Einfachbindung, S, C₁- bis C₆-Alkylen oder C₂- bis C₅-Alkyliden, bevorzugt für eine Einfachbindung, C₃-Alkylen oder Isopropyliden, wobei W keine Einfachbindung ist, wenn q für 1 steht.
p und q stehen unabhängig voneinander jeweils für 0 oder 1.
o steht für eine durchschnittliche Anzahl von Wiederholungseinheiten von 10 bis 400, bevorzugt 10 bis 100, besonders bevorzugt von 15 bis 50, und
m steht für eine durchschnittliche Zahl von 1 bis 10, bevorzugt von 1 bis 6 und besonders bevorzugt von 1,5 bis 5.

Insbesondere bevorzugt sind Siloxane der Formeln (11) und (12) 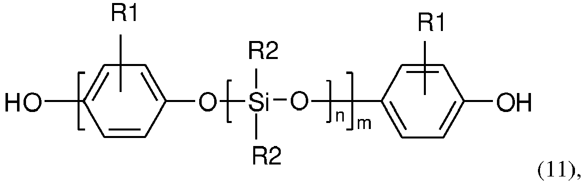 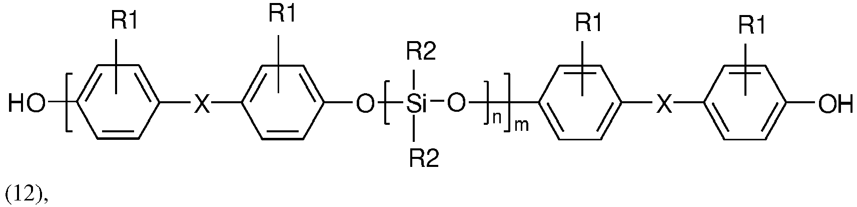
+-wobei R1 für H, Cl, Br oder C₁- bis C₄-Alkyl, vorzugsweise für H oder Methyl, steht und insbesondere bevorzugt für Wasserstoff steht,
R2 für Aryl oder C₁- bis C₄-Alkyl, bevorzugt für Methyl, steht,
X für eine Einfachbindung, -SO₂-, -CO-, -O-, -S-, C₁- bis C₆-Alkylen, C₂- bis C₅-Alkyliden oder für C₆- bis C₁₂-Arylen, welches gegebenenfalls mit weiteren Heteroatome enthaltenden aromatischen Ringen kondensiert sein kann, steht. Bevorzugt steht X für eine Einfachbindung, Isopropyliden, 3,3,5-Trimethylcyclohexyliden oder Sauerstoff, und ganz besonders bevorzugt für Isopropyliden,
n steht für eine durchschnittliche Zahl von 10 bis 400, bevorzugt 10 bis 100, besonders bevorzugt 10 bis 50,
m steht für eine durchschnittliche Zahl von 1 bis 10, bevorzugt von 1 bis 6 und insbesondere bevorzugt von 1,5 bis 5. Das Molekulargewicht der Siloxanblöcke beträgt 3000 g/mol bis 20.000 g/mol, bevorzugt 3500 g/mol bis 15.000 g/mol, bestimmt mittels Gelpermeationschromatographie (GPC) und Polycarbonat aus Bisphenol A als Diphenol als Standar, wie oben beschrieben.

Die Herstellung der Siloxanblöcke ist prinzipiell bekannt und kann nach Verfahren wie beispielsweise in US 2013/0267665 A1 beschrieben hergestellt werden.

Die Herstellung von Polycarbonaten ist ebenfalls bekannt. Die Herstellung der Polycarbonate erfolgt in bekannter Weise aus Diphenolen, Kohlensäurederivaten, gegebenenfalls Kettenabbrechern und Verzweigern.

Einzelheiten der Herstellung von Polycarbonaten sind in vielen Patentschriften seit etwa 40 Jahren niedergelegt. Beispielhaft sei hier nur auf Schnell, "Chemistry and Physics of Polycarbonates", Polymer Reviews, Volume 9, Interscience Publishers, New York, London, Sydney 1964, auf D. Freitag, U. Grigo, P.R. Müller, H. Nouvertne', BAYER AG, "Polycarbonates" in Encyclopedia of Polymer Science and Engineering, Volume 11, Second Edition, 1988, Seiten 648-718 und schließlich auf Dres. U. Grigo, K. Kirchner und P.R.

Müller "Polycarbonate" in Becker/Braun, Kunststoff-Handbuch, Band 3/1, Polycarbonate, Polyacetale, Polyester, Celluloseester, Carl Hanser Verlag München, Wien 1992, Seiten 117-299 verwiesen.

Bevorzugte Herstellungsweisen für Polycarbonate sind das bekannte Grenzflächenverfahren und das bekannte Schmelzumesterungsverfahren (z. B. WO 2004/063249 A1, WO 2001/05866 A1, WO 2000/105867, US-A 5,340,905, US 5,097,002, US-A 5,717,057).

Der Gehalt an Siloxanblöcken im SiCoPC beträgt größer 0, bevorzugt 0,5 bis 40 Gew.-%, bevorzugt 1 bis 20 Gew.-%, insbesondere bevorzugt 2 bis 15 Gew.-% und ganz besonders bevorzugt 2 bis 10 Gew.-%, jeweils bezogen auf die eingesetzten Siloxanblöcke und Polycarbonatblöcke. Entsprechend beträgt der Anteil der Polycarbonatblöcke im Blockcokondensat 60 bis kleiner 100 (bevorzugt 99,5) Gew.-%, bevorzugt 99 bis 80 Gew.- %, insbesondere bevorzugt 98 bis 85 Gew.-% und ganz besonders bevorzugt 98 bis 90 Gew.- %.

Die oben genannten Siloxanblöcke werden bevorzugt mit Polycarbonaten mit Molekulargewichten von 15.000 bis 27.000 g/mol, insbesondere bevorzugt von 17.000 bis 27.000 g/mol und insbesondere bevorzugt von 18.000 bis 26.500 g/mol (gemessen mittels GPC mit BPA-Polycarbonat als Standard, wie oben beschrieben) umgesetzt.

Die Diphenole zur Herstellung der Polycarbonate sind die oben genannten Struktureinheiten (3).

Dabei werden die einzelnen Komponenten (Siloxan-Block und Polycarbonat-Block) nach dem Reaktivextrusionsverfahren oder alternativ die Siloxanblöcke mit Diphenolen der Formel (3) mit Phosgen oder Diarylcarbonaten nach dem bekannten Phasengrenzflächenverfahren umgesetzt. Dieses Verfahren zur Polycarbonatsynthese ist mannigfaltig in der Literatur beschrieben; beispielhaft sei auf H. Schnell, Chemistry and Physics of Polycarbonates, Polymer Reviews, Vol. 9, Interscience Publishers, New York 1964 S. 33 ff., auf Polymer Reviews, Vol. 10, "Condensation Polymers by Interfacial and Solution Methods", Paul W. Morgan, Interscience Publishers, New York 1965, Kap. VIII, S. 325, auf Dres. U. Grigo, K. Kircher und P. R- Müller "Polycarbonate" in Becker/Braun, Kunststoff-Handbuch, Band 3/1, Polycarbonate, Polyacetale, Polyester, Celluloseester, Carl Hanser Verlag München, Wien 1992, S. 118-145 sowie auf EP-A 0 517 044 verwiesen. Die Umsetzung von Polyorganosiloxanen im Phasengrenzflächenverfahren ist z.B. in US 3821325 A beschrieben.

Die Herstellung der SiCoPCs kann in einem Reaktivextrusionsverfahren, wie es beispielsweise in WO 2015/052110 A1 beschrieben ist, erfolgen.

### Komponente B)

Erfindungsgemäß wird als Komponente B) unbeschlichteter Talk verwendet. Dies bedeutet, dass der Talk vor der Vermischung mit Komponente A) keine Schlichte aufweist.

Talk im Sinne der vorliegenden Erfindung ist bevorzugt ein Talk, welcher im Wesentlichen die gleiche chemische Zusammensetzung, Partikeldurchmesser, Porosität und/oder BET-Oberfläche aufweist, oder ein Talkgemisch.

Bei Talk handelt es sich im Allgemeinen um ein Schichtsilikat. Es kann beschrieben werden als Magnesiumsilikathydrat mit der allgemeinen chemischen Zusammensetzung Mg₃[Si₄O₁₀(OH)₂]. Unterschiedliche Talkarten enthalten jedoch unterschiedliche Verunreinigungen, so dass Abweichungen von dieser allgemeinen Zusammensetzung vorliegen können.

Der Talk oder das Talkgemisch ist erfindungsgemäß zum Zeitpunkt der Zugabe zur Komponente A) und C) unbeschlichtet. Im Sinne der vorliegenden Erfindung wird eine Schlichte als eine gezielte (chemi- oder physisorbierte) Anreicherung von Molekülen unterschiedlich von Talkum, insbesondere Mg₃[Si₄O₁₀(OH)₂], an der Oberfläche betrachtet. Bei unbeschlichtetem Talk handelt es sich somit um nicht oberflächen-behandelten Talk, d. h. nach der Gewinnung der Talkpartikel mit dem gewünschten Partikeldurchmesser und gegebenenfalls einer Kompaktierung wurde der Talk bevorzugt keinem weiteren Verfahrensschritt unterzogen, welcher die Oberfläche des Talks durch Chemisorption oder Physisorption gezielt verändert. Dies schließt jedoch nicht aus, dass unbeabsichtigt Verunreinigungen, Staub oder ähnliche Partikel während der weiteren Handhabung des Talks an Teile der Oberfläche gelangen, solange die Oberfläche des Talks nicht wesentlich ihre Eigenschaften, insbesondere in Bezug auf den pH-Wert, verliert. Erfindungsgemäß wird der Talk erst durch die Vermischung mit der Komponente C) beschlichtet.

Bevorzugt weist der Talk einen pH-Wert von 8 bis 10, besonders bevorzugt 8,5 bis 9,8, ganz besonders bevorzugt 9,0 bis 9,7 auf, wobei der pH-Wert bestimmt wird gemäß EN ISO 787-9:1995. Es ist zu beachten, dass die EN ISO 787-9:1995 auch die Möglichkeit der Zugabe von Ethanol oder anderen organischen Lösungsmitteln zur Verbesserung der Dispergierung des zu vermessenden Feststoffes erwähnt. Bevorzugt wird erfindungsgemäß nur destilliertes Wasser zur Bestimmung des pH-Wertes gemäß EN ISO 787-9:1995 eingesetzt.

Die Komponente B) weist bevorzugt einen Gehalt an Eisen(II)oxid und/oder Eisen(III)oxid von 0,2 bis 2,5 Gew.-%, besonders bevorzugt 0,3 bis 2,3 Gew.-%, ganz besonders bevorzugt von 0,3 bis 2,0 Gew.-% auf. Dieser Gehalt wird bevorzugt gemessen durch Röntgenfluoreszenz oder Atomabsorptionsspektroskopie. Es hat sich herausgestellt, dass der Gehalt an Eisenoxid im Talk einen Einfluss auf den Grad des Abbau des Polycarbonats aufweist. Im erfindungsgemäß angegebenen Gehaltsbereich an Eisenoxid wurden besonders gute Ergebnisse in Bezug auf die Verminderung des Abbaus des Polycarbonats erzielt.

Ebenso bevorzugt weist die Komponente B) einen Gehalt an Aluminiumoxid von 0,01 bis 0,5 Gew.-%, besonders bevorzugt von 0,05 bis 0,48 Gew.-%, ganz besonders bevorzugt von 0,15 bis 0,45 Gew.-% auf.

Die Komponente B) weist einen mittleren Partikeldurchmesser D50 von 0,01 bis 9,5 µm auf, bevorzugt 0,25 bis 8,00 µm, besonders bevorzugt 0,5 bis 6,00 µm und ganz besonders bevorzugt 0,5 µm bis kleiner oder gleich 3,0 µm auf, wobei der Partikeldurchmesser D50 bestimmt wird durch Sedimentationsanalyse. Unter dem Mittelwert D50 versteht der Fachmann einen mittleren Partikeldurchmesser, bei dem 50 % der Partikel kleiner sind als der definierte Wert. Bevorzugt wird der Partikeldurchmesser D50 bestimmt gemäß ISO13317-3:2001.

Komponente B) weist bevorzugt eine BET-Oberfläche von 7,5 bis 20,0 m²/g, besonders bevorzugt von 9,0 bis 15,0 m²/g, ganz besonders bevorzugt 9,5 bis 14,0 m²/g auf. Die Bestimmung der Oberfläche nach Brunauer, Emmett und Teller mittels Gasadsorption ist dem Fachmann an sich bekannt. Bevorzugt wird die BET-Oberfläche von Komponente B) gemäß ISO 4652:2012 bestimmt. Diese bevorzugte BET-Oberfläche wird besonders bevorzugt mit dem oben beschriebenen mittleren Partikeldurchmesser D50-Wert des Talks verbunden. Es hat sich herausgestellt, dass bei einer solchen Kombination die erfindungsgemäß eingesetzte Komponente B) optimal auf die erfindungsgemäß eingesetzte Komponente C) abgestimmt ist. Durch die spezielle Säurezahl und Molmasse der Komponente C) kann der Abbau des Polycarbonats, welcher durch die Komponente B) verursacht wird, minimiert werden, da unter diesen Bedingungen insbesondere auch die Poren des Talks für das Wachs C) zugänglich sind.

Besonders bevorzugt weist der Talk einen Talkgehalt von ≥ 96 Gew.-%, besonders bevorzugt ≥ 97 Gew.-%, ganz besonders bevorzugt ≥ 98 Gew.-% auf.

Ebenso ist es bevorzugt, dass der Talk einen Glühverlust bei 1050 °C von 5,0 bis 7,0 Gew.- %, besonders bevorzugt von 5,2 bis 6,5 Gew.-% und ganz besonders bevorzugt von 5,3 bis 6,2 Gew.-% aufweist. Der Glühverlust wird bevorzugt mittels DIN51081:2002 bestimmt.

Der Talk oder das Talkgemisch gemäß Komponente B) liegt bevorzugt kompaktiert vor.

### Komponente C)

Die Komponente C) im Sinne der vorliegenden Erfindung ist ein anhydridmodifiziertes alpha-Olefin-Polymer mit einer Säurezahl von mindestens 30 mg KOH/g und einem mittleren Molekulargewicht Mw von 4.000 bis 40.000 g/mol. Dabei kann es sich auch um eine Mischung verschiedener Polymere handeln, welche die Merkmale gemäß Komponente C) erfüllen.

Das alpha-Olefin-Polymer enthält vorzugsweise mindestens einen Baustein ausgewählt aus der Gruppe, bestehend aus Ethylen, 1-Propen, 1-Buten, 1-Isobuten, 1-Penten, 1-Hexen, 1-Hepten, 1-Octen, 1-Nonen, 1-Decen, 1-Undecen, 1-Dodecen, 1-Tridecen, 1-Tetradecen, 1-Octadecen, 1-Nonadecen sowie Gemische aus diesen. Besonders bevorzugt umfasst das alpha-Olefin-Polymer mindestens einen Baustein, welcher ausgewählt ist aus der Gruppe, bestehend aus Ethylen, 1-Propen, 1-Octen.

Bevorzugtes Anhydrid als weiterer Baustein zur Modifizierung ist ein ungesättigtes Carbonsäureanhydrid, welches vorzugsweise ausgewählt ist aus mindestens einem, ausgewählt aus der Gruppe, bestehend aus Maleinsäureanhydrid, Phthalsäureanhydrid, Fumarsäureanhydrid, Itaconsäureanhydrid. Besonders bevorzugt ist Maleinsäureanhydrid.

Das anhydridmodifizierte alpha-Olefin-Polymer ist bevorzugt kautschukfrei.
Bevorzugt umfasst das alpha-Olefin-Polymer (Komponente C)
Ca) 90,0-98,0 Gew.-%, vorzugsweise 92,0-97,5 Gew.-%, besonders bevorzugt 94,0-97,0 Gew.-% alpha-Olefin-Polymer und
Cb) 2,0-10,0 Gew.-%, vorzugsweise 2,5-8,0 Gew.-%, und besonders bevorzugt 3,0-6,0 Gew.-% Anhydrid.
Der olefinische Teil Ca) des alpha-Olefin-Polymers ist bevorzugt dadurch gekennzeichnet, dass
der Ethylenanteil 80,0-96,0 Gew.-%, bevorzugt 84,0-92,0 Gew.-%,
der Propylenanteil 2,0-10,0 Gew.-%, bevorzugt 4,0-8,0 Gew.-% und
der Octenanteil 2,0-10,0 Gew.-%, bevorzugt 4,0-8,0 Gew.-%, ist.

Ebenso bevorzugt besteht der olefinische Teil Ca) des alpha-Olefin-Polymers aus Propylen und/oder Ethylen. Weiterhin bevorzugt besteht der olefinische Teil Ca) des alpha-Olefin-Polymers aus Propylen.

Die Säurezahl des erfindungsgemäß eingesetzten Wachses der Komponente C) beträgt mindestens 30 mg KOH/g. Bevorzugt beträgt die Säurezahl 30 bis 110 mg KOH/g, besonders bevorzugt 40 bis 95 mg KOH/g. Die Säurezahl wurde von der Currenta GmbH mittels potentiometrischer Titration mit alkoholischer Kaliumhydroxid-Lösung gemäß DIN ISO 17025:2005 bestimmt.

Das mittlere Molekulargewicht Mw des anhydridmodifzierten alpha-Olefin-Polymers beträgt 4.000 bis 40.000 g/mol, bevorzugt 4.000 bis 32.000 g/mol, besonders bevorzugt 4.800 bis 25.000 g/mol. Das Molekulargewicht Mw wird bestimmt mittels Gelpermeationschromatographie in ortho-Dichlorbenzol bei 150 °C mit Polystyrolkalibrierung. Hierbei ist der angegebene Wert bevorzugt der Mittelwert aus einer Doppelbestimmung.

Bevorzugt beträgt bei kleineren Molekulargewichten von 4.000 bis 10.000 g/mol die Säurezahl 30 bis 65 mg, besonders bevorzugt 40 bis 60 mg KOH/g. Besonders bevorzugt beträgt das Molekulargewicht für die jeweils genannten Säurezahl von 30 mg bis 65 mg bzw. 40 bis 60 mg KOH/g 4.500 bis 8.000 g/mol und insbesondere 5.000 bis 7.000 g/mol.

Bevorzugt beträgt bei größeren Molekulargewichten von 12.000 bis 40.000 g/mol die Säurezahl 30 mg bis 100 mg KOH/g, insbesondere 35 mg bis 95 mg KOH/g. Besonders bevorzugt beträgt das Molekulargewicht für die jeweils genannten Säurezahl von 30 mg bis 100 mg bzw. 35 bis 95 mg KOH/g 12.000 bis 32.000 g/mol und insbesondere 15.000 bis 25.000 g/mol, ganz besonders bevorzugt 17.500 bis 23.000 g/mol.

Die Kombination der (Mindest)Säurezahl und Molmasse des Wachses C) wie oben angegeben ist besonders geeignet, um insbesondere die multiaxiale Schlagzähigkeit von aus den erfindungsgemäßen Zusammensetzungen hergestellten Formteilen zu optimieren.

### Komponente D

Als optionale Komponente D) kommen als weitere Füllstoffe expandierter Graphit alleine oder in Mischung mit nicht expandiertem Graphit und/oder Bornitrid in Frage.

### Expandierter Graphit:

Als Komponente D wird Graphit, bevorzugt expandierter Graphit, alleine oder in Mischung mit nicht expandiertem Graphit, besonders bevorzugt nur expandierter Graphit, verwendet.

Bei den expandierten Graphiten sind die einzelnen Basalebenen des Graphits durch eine spezielle Behandlung auseinandergetrieben, wodurch eine Volumenvergrößerung des Graphits, bevorzugt um den Faktor 200 bis 400, resultiert. Die Herstellung von expandierten Graphiten ist unter anderem in den Schriften US 1,137,373 A, US 1,191,383 A sowie US 3,404,061 A beschrieben.

Im Folgenden wird unter Graphit expandierter Graphit verstanden, es sei denn, es wird explizit auf nicht expandierten Graphit verwiesen.

Graphite werden in Form von Fasern, Stäbchen, Kugeln, Hohlkugeln, Plättchen, in Pulverform, jeweils sowohl in aggregierter als auch in agglomerierter Form, bevorzugt in Plättchenform, in den Zusammensetzungen verwendet. Unter der plättchenförmigen Struktur wird in der vorliegenden Erfindung ein Partikel verstanden, der eine flache Geometrie aufweist. So ist die Höhe der Partikel üblicherweise deutlich geringer im Vergleich zu der Breite oder Länge der Partikel. Derartige flache Partikel können wiederum zu Gebilden agglomeriert oder aggregiert sein. Die Dicke der plättchenförmigen Primärpartikel beträgt weniger als 500 nm, bevorzugt weniger als 200 nm und besonders bevorzugt weniger als 100 nm. Durch die kleinen Größen dieser Primärpartikel kann die Form der Partikel gebogen, gekrümmt, gewellt oder andersartig deformiert sein. Die Längendimensionen der Partikel können durch Standardmethoden, zum Beispiel die Elektronenmikroskopie, ermittelt werden.

Erfindungsgemäß bevorzugt wird ein Graphit mit einer relativ hohen spezifischen Oberfläche, ermittelt als BET-Oberfläche mittels Stickstoffadsorption nach DIN ISO 9277:2010, verwendet. Bevorzugt werden Graphite mit einer BET-Oberfläche von > 5 m²/g, besonders bevorzugt > 10 m²/g und ganz besonders bevorzugt > 18 m²/g in den thermoplastischen Zusammensetzungen eingesetzt.

Der Partikeldurchmesser D50 Wert des Graphits, üblicherweise bestimmt durch Siebanalyse gemäß DIN 51938:2015-09 für Pulver mit einem D50 ≥150µm oder durch Laserbeugung gemäß ISO 13320:2009 für Pulver mit einem D50 < 150µm, ist bevorzugt < 800µm, besonders bevorzugt <600µm, ganz besonders bevorzugt <220 µm insbesondere bevorzugt <150µm. Für besonders gute Oberflächenqualitäten sind Graphite mit einer Partikelgrößenverteilung, welche durch den D90 Wert charakterisiert werden, von <600µm, besonders bevorzugt von <300µm, bevorzugt. Die D50 und D90 Werte werden durch Siebanalyse in Anlehnung an DIN 51938:2015-09 oder durch Laserbeugung gemäß ISO 13320:2009 ermittelt. D50 bedeutet, dass 50 % der Partikel einen Partikeldurchmesser kleiner oder gleich des angegebenen Werts aufweisen. D90 bedeutet, dass 90 % der Partikel einen Partikeldurchmesser kleiner oder gleich des angegebenen Werts aufweisen. D0,5 bzw. D0.9 sind äquivalente Bezeichnungen. Zu beachten ist, dass im Falle der Siebanalyse nach DIN 51938:2015-09 die Kennwerte D50 bzw. D90 auf das Gewicht bezogen werden (Gew.%), nicht wie bei der der Laserbeugung auf die Anzahl der analysierten Partikel im Probenvolumen.

Der Kohlenstoffgehalt der erfindungsgemäß verwendeten Graphite, ermittelt nach DIN 51903 bei 800 °C für 20 Stunden, beträgt vorzugsweise > 90 Gew.%, weiter bevorzugt > 95 Gew.% und noch weiter bevorzugt > 97 Gew.%.

Der Restfeuchtigkeitsgehalt der erfindungsgemäß verwendeten Graphite, ermittelt nach DIN 51904:2012-11 bei 110 °C für 8 Stunden, beträgt vorzugsweise < 5 Gew.%, weiter bevorzugt < 3 Gew.% und noch weiter bevorzugt < 2 Gew.%.

Kommerziell verfügbare expandierte und nicht expandierte Graphite sind unter anderem Ecophit^{®} GFG 5, Ecophit^{®} GFG 50, Ecophit^{®} GFG 200, Ecophit^{®} GFG 350, Ecophit^{®} GFG 500, (mittlerweile erhältlich unter der Produktbezeichung Sigratherm^{®}) von der Firma SGL Carbon GmbH, TIMREX^{®} BNB90, TIMREX^{®} KS5-44, TIMREX^{®} KS6, TIMREX^{®} KS150, TIMREX^{®} SFG44, TIMREX^{®} SFG150, TIMREX^{®} C-THERM^{™} 001 und TIMREX^{®} C-THERM^{™} 011, sowie C-THERM^{™} 002von der Firma TIMCAL Ltd. bzw. Imerys Graphite & Carbon Switzerland Ltd.,.

### Bornitrid:

Erfindungsgemäß kann das verwendete Bornitrid ein kubisches Bornitrid, ein hexagonales Bornitrid, ein amorphes Bornitrid, ein partiell kristallines Bornitrid, ein turbostratisches Bornitrid, ein wurtzitisches, ein rhomboedrisches Bornitrid und/oder eine weitere allotrope Form sein, wobei die hexagonale Form bevorzugt ist.

Die Herstellung von Bornitrid ist beispielsweise in den Schriften US 6,652,822 B2, US 2001/0021740 A1, US 5,898,009 A, US 6,048,511 A, US 2005/0041373 A1, US 2004/0208812 A1, US 6,951,583 B2 sowie in WO 2008/042446 A2 beschrieben.

Das Bornitrid kann in Form von Plättchen, Pulvern, Nanopulvern, Fasern sowie Agglomeraten oder einer Mischung zuvor genannter Formen verwendet werden.

Bevorzugt wird eine Mischung aus diskretem plättchenförmigen Bornitrid und Agglomeraten genutzt.

Bevorzugte Bornitride weisen üblicherweise eine agglomerierte Partikelgröße (D50-Wert) von 1 µm bis 100 µm, bevorzugt von 3 µm bis 60 µm, besonders bevorzugt von 5 µm bis 30 µm, ermittelt durch Laserbeugung gemäß ISO 13320:2009, auf.

Bei der Laserbeugung werden Partikelgrößenverteilungen durch Messung der Winkelabhängigkeit der Intensität von gestreutem Licht eines Laserstrahls, der eine dispergierte Partikelprobe durchdringt, ermittelt. Hierbei wird die Mie-Theorie der Lichtstreuung zur Berechnung der Partikelgrößenverteilung verwendet. Als Messinstrument kann beispielsweise Microtac S3500 verwendet werden. Der D50-Wert bedeutet, dass 50 % aller vorkommenden Partikel in dem untersuchten Material kleiner als oder gleich groß wie der angegebene Wert sind.

In einer weiteren Ausführungsform der vorliegenden Erfindung werden Bornitride mit einem D50-Wert von 0,1 µm bis 50 µm, bevorzugt von 1 µm bis 30 µm, besonders bevorzugt von 3 µm bis 25 µm, ermittelt durch Laserbeugung wie oben beschrieben, genutzt, bevorzugt handelt es sich dabei um hexagonale Bornitride

Bornitride können mit unterschiedlichen Partikelgrößenverteilungen in den erfindungsmäßen Zusammensetzungen eingesetzt werden.

In einer weiteren Ausführungsform der vorliegenden Erfindung werden zwei Bornitride mit unterschiedlicher Partikelgrößenverteilung genutzt, wodurch eine bimodale Verteilung in der Zusammensetzung entsteht.

Der Kohlenstoffgehalt der verwendeten Bornitride beträgt ≤ 1 Gew.-%, bevorzugt ≤ 0,5 Gew.-%, besonders bevorzugt ≤ 0,2 Gew.-%.

Die Reinheit der Bornitride, das heißt der Anteil an reinem Bornitrid in dem jeweils genutzten Zuschlagstoff, beträgt mindestens 90 Gew. %, bevorzugt mindestens 95 Gew. % und weiterhin bevorzugt mindestens 97 Gew. %.

Die erfindungsgemäß verwendeten Bornitride weisen im Allgemeinen eine BET-Oberfläche, nach ISO 9277:2010, von 0,1 m²/g bis 25 m²/g, bevorzugt 1,0 m²/g bis 10 m²/g und besonders bevorzugt 2 m²/g bis 9 m²/g auf.

Die Schüttdichte der Bornitride beträgt vorzugsweise ≤ 1 g/cm³, besonders bevorzugt ≤ 0,8 g/cm³ und ganz besonders bevorzugt ≤ 0,6 g/cm³.

Beispiele für kommerziell verwendbare Bornitride sind Boron Nitride Cooling Filler Platelets 009, Boron Nitride Cooling Filler Platelets 012 und Boron Nitride Cooling Filler Platelets 015/400 HR von 3M^{™} Technical Ceramics oder CoolFlow^{™} Boron Nitride Powder CF500 und CoolFlow^{™} Boron Nitride Powder CF600 Powder von Momentive Performance Materials. Weiterhin können die Bornitride an der Oberfläche modifiziert sein, wodurch die Verträglichkeit der Füllstoffe mit der erfindungsmäßen Zusammensetzung erhöht wird. Geeignete Modifikatoren sind unter anderen organische, beispielsweise Silicium-organische Verbindungen.

Beispiele für kommerziell verwendbare Bornitride sind Bornitrid Cooling Filler TP 15/400 von der Firma ESK Ceramics GmbH & Co. KG, HeBoFill^{®} 511, HeBoFill^{®} 501, HeBoFill^{®} 483,

HeBoFill^{®} 482 von der Firma Henze Boron Nitride Products AG und CoolFlow^{™} CF400, CoolFlow^{™} CF500, CoolFlow^{™} CF600 sowie PolarTherm PT110 von der Firma Momentive Performance Materials.

Weiterhin können die Bornitride an der Oberfläche modifiziert sein, wodurch die Verträglichkeit der Füllstoffe mit der erfindungsmäßen Zusammensetzung erhöht wird. Geeignete Modifikatoren sind unter anderen organische, beispielsweise Silicium-organische Verbindungen.

### Zusammensetzung

In der erfindungsgemäßen Zusammensetzung sind die Mengen von B) und C) vor der Vermischung der Komponenten A) bis C) so aufeinander abgestimmt, dass pro 10 Gewichtsteile der Komponente B) 0,10 bis 1,4 Gewichtsteile der Komponente C) eingesetzt werden. Bevorzugt werden pro 10 Gewichtsteile der Komponente B) 0,2 bis 1,2, besonders bevorzugt 0,3 bis 1,1 Gewichtsteile der Komponente C), ganz besonders bevorzugt 0,4 bis 1,0 Gewichtsteile der Komponente C) eingesetzt.

Bevorzugt enthält die erfindungsgemäße Zusammensetzung 12,0 bis 45,0 Gew.-% der Komponente B) bezogen auf die Gesamtzusammensetzung.

Besonders bevorzugt enthält die Zusammensetzung 15,0 bis 42,0 Gew.-%, ganz besonders bevorzugt 18,0 bis 35,0 Gew.-% der Komponente B), jeweils bezogen auf die Gesamtzusammensetzung. Die Menge der Komponente C) ergibt sich aus den oben angegebenen Mengen pro 10 Gewichtsteile Komponente B).

Optional kann zur weiteren Verbesserung der Wärmeleitfähigkeit und Dimensionsstabilität auch noch Komponente D) zugesetzt werden, wobei Komponente D) eine entsprechende Menge an Komponente B) ersetzt. Wenn Komponente D) ein Graphit ist, können 0,0 bis 8,0 Gewichtsteile der Komponente B) ersetzt werden. Wenn Komponente D) ein Bornitrid ist, können 0,0 bis 15,0 Gewichtsteile der Komponente B) durch Komponente D) ersetzt werden. Falls ein Graphit als Komponente D) zugesetzt wird, werden bevorzugt 2,0 bis 7,0 Gewichtsteile B) durch Komponente D) ersetzt. Falls ein Bornitrid als Komponente D) zugesetzt wird, werden bevorzugt 2,0 bis 12,0 Gewichtsteile B) durch Komponente D) ersetzt.

Die Zusammensetzung ist frei von Pfropfpolymerisaten und Polyestern, bevorzugt von Komponente C) verschiedenen Schlagzähmodifikatoren ("Impact Modifiern").

Unter "Pfropfpolymerisaten" werden insbesondere Pfropfpolymerisate mit kautschukelastischen Eigenschaften verstanden, die im Wesentlichen aus mindestens zwei der nachfolgenden Monomere erhältlich sind: Chloropren, 1,3-Butadien, Isopren, Styrol, Acrylnitril, Ethylen, Propylen, Vinylacetat und (Meth)Acrylsäureester mit 1 bis 18 C-Atomen in der Alkoholkomponente; also Polymerisate, wie sie z.B. in "Methoden der Organischen Chemie" (Houben-Weyl), Bd. 14/1, Georg Thieme-Verlag, Stuttgart 1961, S. 393-406 und in C.B. Bucknall, "Toughened Plastics", Appl. Science Publishers, London 1977, beschrieben sind. Pfropfpolymerisate können partiell vernetzt sein und Gelgehalte (gemessen in Toluol) von über 20 Gew.-% aufweisen, vorzugsweise über 40 Gew.-%, insbesondere über 60 Gew.-%, wobei der Gelgehalt bei 25°C in einem geeigneten Lösungsmittel bestimmt wird (M. Hoffmann, H. Krömer, R. Kuhn, Polymeranalytik I und II, Georg Thieme-Verlag, Stuttgart 1977).

Pfropfpolymerisate sind beispielsweise Pfropfpolymerisate aus:
a.i) 5 bis 95 Gew.-Teile, vorzugsweise 30 bis 80 Gew.-Teile, einer Mischung aus
a.i.1) 50 bis 95 Gew.-Teilen Styrol, α-Methylstyrol, methylkemsubstituiertem Styrol, C₁- bis C₈-Alkylmethacrylat, insbesondere Methylmethacrylat, C₁- bis C₈-Alkylacrylat, insbesondere Methylacrylat, oder Mischungen dieser Verbindungen
   und
a.i.2) 5 bis 50 Gew.-Teilen Acrylnitril, Methacrylnitril C₁- bis C₈-Alkylmethacrylaten, insbesondere Methylmethacrylat, C₁- bis C₈-Alkylacrylat, insbesondere Methylacrylat, Maleinsäureanhydrid, C₁- bis C₄-Alkyl- bzw. -Phenyl-N-substituierte Maleinimide oder Mischungen dieser Verbindungen auf
a.ii) 5 bis 95 Gew.-Teile, vorzugsweise 20 bis 70 Gew.-Teilen einer kautschukhaltigen Pfropfgrundlage.

Pfropfpolymere sind insbesondere solche mit einer Pfropfgrundlage auf Basis eines Polybutadienkautschuks.

Pfropfpolymerisate sind z.B. mit Styrol und/oder Acrylnitril und/oder (Meth- )Acrylsäurealkylestern gepfropfte Polybutadiene, Butadien/Styrol-Copolymerisate und Acrylatkautschuke; d.h. Copolymerisate der in der DEOS 1 694 173 (= US-PS 3 564 077) beschriebenen Art; mit Acryl- oder Methacrylsäurealkylestern, Vinylacetat, Acrylnitril, Styrol und/oder Alkylstyrolen gepfropfte Polybutadiene, Butadien/Styrol- oder Butadien/Acrylnitril-Copolymerisate, Polyisobutene oder Polyisoprene, wie sie z.B. in der DE-OS 2 348 377 (= US-PS 3 919 353) beschrieben sind.

Pfropfpolymerisate sind insbesondere auch solche, die durch Pfropfreaktion von
I. mindestens einem (Meth-)Acrylsäureester oder einem Gemisch aus Acrylnitril oder (Meth- )Acrylsäureester und Styrol auf
II. einem Butadien-Polymerisat mit Butadienresten als Pfropfgrundlage
   erhältlich sind.

(Meth-)Acrylsäureester I sind Ester der Acrylsäure oder Methacrylsäure und einwertiger Alkohole mit 1 bis 18 C-Atomen, insbesondere Methacrylsäuremethylester, -ethylester und - propylester.

Die Pfropfgrundlage II kann neben Butadienresten auch Reste anderer ethylenisch ungesättigter Monomerer, wie Styrol, Acrylnitril, Ester der Acryl- oder Methacrylsäure mit 1 bis 4 C-Atomen in der Alkoholkomponente (wie Methylacrylat, Ethylacrylat, Methylmethacrylat, Ethylmethacrylat), Vinylester und/oder Vinylether enthalten. Eine Pfropfgrundlage II besteht beispielsweise aus reinem Polybutadien.

Da bei der Pfropfreaktion die Pfropfmonomeren bekanntlich nicht unbedingt vollständig auf die Pfropfgrundlage aufgepfropft werden, werden erfindungsgemäß unter Pfropfpolymerisaten B auch solche Produkte verstanden, die durch Polymerisation der Pfropfmonomeren in Gegenwart der Pfropfgrundlage gewonnen werden.

Pfropfpolymerisate sind z.B. auch Pfropfpolymerisate aus
(a) Acrylatkautschuk als Pfropfgrundlage und
(b) einem polymerisierbaren, ethylenisch ungesättigten Monomeren, dessen bzw. deren in Abwesenheit von a) entstandenen Homo- bzw. Copolymerisate als Pfropfmonomere.

Die Acrylatkautschuke (a) des Pfropfpolymerisats sind insbesondere Polymerisate aus Acrylsäurealkylestern, gegebenenfalls mit anderen polymerisierbaren, ethylenisch ungesättigten Monomeren.

Polymerisierbare Acrylsäureester sind C₁- bis C₈-Alkylester, beispielsweise Methyl-, Ethyl-, n-Butyl-, n-Octyl- und 2-Ethylhexylester sowie Mischungen dieser Monomeren.

Zur Vernetzung können Monomere mit mehr als einer polymerisierbaren Doppelbindung copolymerisiert werden.

Beispiele für vernetzende Monomere sind Ester ungesättigter Monocarbonsäuren mit 3 bis 8 C-Atomen und ungesättigter einwertiger Alkohole mit 3 bis 12 C-Atomen oder gesättigter Polyole mit 2 bis 4 OH-Gruppen und 2 bis 20 C-Atomen, wie z.B. Ethylenglykoldimethacrylat, Allylmethacrylat; mehrfach ungesättigte heterocyclische Verbindungen, wie z.B. Trivinyl- und Triallylcyanurat; polyfunktionelle Vinylverbindungen, wie Di- und Trivinylbenzole; aber auch Triallylphosphat und Diallylphthalat.

Bevorzugte "andere" polymerisierbare, ethylenisch ungesättigte Monomere, die neben den Acrylsäureestern gegebenenfalls zur Herstellung der Pfropfgrundlage (a) dienen können, sind z.B. Acrylnitril, Styrol, α-Methylstyrol, Acrylamide, Vinyl-C₁- bis -C₆-alkylether, Methylmethacrylat, Butadien.

Beispiele für entsprechende Schlagzähmodifikatoren sind ABS (Acrylnitril-Butadien-Styrol), SBR (Styrol-Butadien-Rubber) und SAN (Styrol-Acrylnitril).

Impact Modifier sind auch Vinyl(co)polymerisate.

Pfropfgrundlagen sind auch Silikonkautschuke.

Impact-Modifier sind auch Kern-Schale-Systeme, z.B. Silikon-Acryl-Schlagzähmodifizierer, etwa mit Silikonelastomer-Kern und MMA-Copolymer-Schale, wie Metablen S-2001.

Impact Modifier sind auch höhermolekulare, ggf. funktionalisierte, Polyolefine, sowohl Homo- als auch Copolymere, die von Komponente C) verschieden sind. Bei diesen erfolgt die Funktionalisierung z.B. mittels aromatischer Monovinyl-Monomere, Acrylsäuren bzw. Methacrylsäuren und/oder deren Estern, konjugierten Dienen.

Als Impact Modifier üblicherweise verwendete Polyester sind im weitesten Sinne als Kondensate aus Dicarbonsäuren und Diolen (Dialkoholen) darstellbar, insbesondere Polyethylenterephthalat, Polybutylenterephthalat sowie Polyethylennaphthalat oder der Copolyester Tritan der Eastman Chemical Company.

Besonders bevorzugt besteht die Zusammensetzung im Wesentlichen aus den Komponenten A) bis C), wobei aber übliche Additive, die im Folgenden aufgeführt sind, enthalten sein können, und grundsätzlich auch weitere Bestandteile, die sich nicht negativ auf die gewünschten Eigenschaften, insbesondere die multiaxiale Schlagzähigkeit auswirken. Ganz besonders bevorzugt besteht die Zusammensetzung aus den Komponenten A) bis C) sowie den unten genannten Additiven und ist also insbesondere frei von von Komponente C) verschiedenen Impact Modifiern. "Von Komponente C) verschieden" ist so bezeichnet, da anhydridmodifierte alpha-Olefin-Polymere in der Literatur teilweise als Impact Modifier bezeichnet werden, dann üblicherweise aber in höheren Mengen und/oder mit höherem mittleren Molekulargewicht eingesetzt werden.

Die erfindungsgemäße Zusammensetzung umfasst bevorzugt mindestens ein Additiv, ausgewählt aus der Gruppe, bestehend aus Flammschutzmitteln, Antitropfmitteln, Thermostabilisatoren, Entformungsmitteln, Antioxidantien, UV-Absorbern, IR-Absorbern, Antistatika, optischen Aufhellern, Lichtstreumitteln, Farbmitteln. Dabei können diese weiteren Bestandteile vor der Vermischung der Komponenten A) bis D), bei der Vermischung der Komponenten A) bis D) oder nach der Vermischung der Komponenten A) bis D) hinzugegeben werden.

Die Additive sind optional bis zu 10,0 Gew.-%, bevorzugt zu 0,10 bis 8,0 Gew.-%, besonders bevorzugt zu 0,2 bis 3,0 Gew.-% in der erfindungsgemäßen Zusammensetzung enthalten, wobei sich diese Gewichtsprozente auf die Gesamtmasse der Zusammensetzung beziehen.

Solche Additive, wie sie üblicherweise Polycarbonaten zugesetzt werden, sind beispielsweise in EP-A 0 839 623, WO-A 96/15102, EP-A 0 500 496 oder im "Plastics Additives Handbook", Hans Zweifel, 5th Edition 2000, Hanser Verlag, München beschrieben.

Bevorzugte Entformungsmittel sind Ester aliphatischer langkettiger Carbonsäuren mit ein- oder mehrwertigen aliphatischen und/oder aromatischen Hydroxyverbindungen. Besonders bevorzugt sind Pentaerythrittetrastearat, Glycerinmonostearat, Stearylstearat und Propandioldistearat, bzw. Gemische daraus.

Bevorzugte UV-Stabilisatoren weisen eine möglichst geringe Transmission unterhalb 400 nm und eine möglichst hohe Transmission oberhalb von 400 nm auf. Für den Einsatz in der erfindungsgemäßen Zusammensetzung besonders geeignete Ultraviolett-Absorber sind Benzotriazole, Triazine, Benzophenone und/oder arylierte Cyanoacrylate.

Besonders geeignete Ultraviolett-Absorber sind Hydroxy-Benzotriazole, wie 2-(3',5'-Bis-(1,1-dimethylbenzyl)-2'-hydroxy-phenyl)-benzotriazol (Tinuvin^{®} 234, Ciba Spezialitätenchemie, Basel), 2-(2'-Hydroxy-5'-(tert.-octyl)-phenyl)-benzotriazol (Tinuvin^{®} 329, Ciba Spezialitätenchemie, Basel), 2-(2'-Hydroxy-3'-(2-butyl)-5'-(tert.butyl)-phenyl)-benzotriazol (Tinuvin^{®} 350, Ciba Spezialitätenchemie, Basel), Bis-(3-(2H-benztriazolyl)-2-hydroxy-5-tert.-octyl)methan, (Tinuvin^{®} 360, Ciba Spezialitätenchemie, Basel), (2-(4,6-Diphenyl-1,3,5-triazin-2-yl)-5-(hexyloxy)-phenol (Tinuvin^{®} 1577, Ciba Spezialitätenchemie, Basel), sowie der Benzophenone 2,4-Dihydroxy-benzophenon (Chimasorb^{®} 22, Ciba Spezialitätenchemie, Basel) und 2-Hydroxy-4-(octyloxy)-benzophenon (Chimassorb^{®} 81, Ciba, Basel), 2-Cyano-3,3-diphenyl-2-propensäure-2-ethylhexylester, 2,2-Bis[[(2-cyano-1-oxo-3,3-diphenyl-2-propenyl)oxy]-methyl]-1,3-propandiylester (9CI) (Uvinul^{®} 3030, BASF AG Ludwigshafen), 2-[2-Hydroxy-4-(2-ethylhexyl)oxy]phenyl-4,6-di(4-phenyl)phenyl-1,3,5-triazin (CGX UVA 006, Ciba Spezialitätenchemie, Basel) oder Tetraethyl-2,2'-(1,4-phenylen-dimethyliden)-bismalonat (Hostavin^{®} B-Cap, Clariant AG).

Besonders bevorzugte spezielle UV-Stabilisatoren sind beispielsweise Tinuvin^{®} 360, Tinuvin^{®} 350, Tinuvin^{®} 329, Hostavin^{®} B-CAP, besonders bevorzugt TIN 329 und Hostavin^{®} B-Cap. Es können auch Mischungen dieser Ultraviolett-Absorber eingesetzt werden.

Als UV-Stabilisatoren eignen sich bevorzugt 2-(2'-Hydroxyphenyl)benzotriazole, 2-Hydroxybenzophenone, Ester von substituierten und unsubstituierten Benzoesäuren, Acrylate, sterisch gehinderte Amine, Oxamide, 2-(2-Hydroxyphenyl)-1,3,5-triazine, besonders bevorzugt sind substituierte Benztriazole wie beispielsweise Tinuvin 360, Tinuvin 350, Tinuvin 234, Tinuvin 329 oder UV CGX 006 (Ciba). Geeignete Farbmittel können Pigmente, auch anorganische Pigmente, Ruß und/oder Farbstoffe sein. Füllstoffe verschieden von Komponente B) können ebenfalls zugesetzt werden, sofern sie nach Art und Menge das Eigenschaftsniveau der vorliegenden Erfindung nicht beeinträchtigen. Als anorganische Füllstoffe kommen insbesondere Titandioxid, bevorzugt beschlichtetes Titandioxid, im allgemeinen in einer Menge von 0 bis 2,5 Gew.-%, bezogen auf die Summe der Gesamtzusammensetzung, oder Bariumsulfat in Betracht.

Die Zusammensetzung kann weitere handelsübliche Polymeradditive wie Flammschutzmittel, Flammschutzsynergisten, Antidrippingmittel (beispielsweise Verbindungen der Substanzklassen der fluorierten Polyolefine und der Silikone), Nukleiermittel, Antistatika wie Polyalkylenether, Alkylsulfonate oder Polyamid-haltige Polymere) in solchen Mengen enthalten, die die mechanischen Eigenschaften der Zusammensetzung nicht insoweit schädigen, dass das Zieleigenschaftsprofil nicht mehr erfüllt wird.

Geeignete Additive sind beispielsweise, jedoch nicht limitierend, beschrieben in "Additives for Plastics Handbook, John Murphy, Elsevier, Oxford 1999", im "Plastics Additives Handbook, Hans Zweifel, Hanser, München 2001" oder in WO 99/55772 , S. 15-25.

Darüber hinaus können weitere Bestandteile zugesetzt werden, die nach Art des Bestandteils und Menge das Eigenschaftsniveau der vorliegenden Erfindung nicht beeinträchtigen.

Die Herstellung der erfindungsgemäßen Polymer-Zusammensetzungen, enthaltend die vermischten Komponenten A) bis D) und optional Additive sowie weitere Bestandteile, erfolgt gegebenenfalls unter Verwendung von Pulvervormischungen, solange die Komponenten B) und C) tatsächlich erst in der Schmelze der Komponente A) vermischt werden. Unter dieser Voraussetzung können auch Vormischungen aus Granulaten oder Granulaten und Pulvern mit den erfindungsgemäßen Zusätzen verwendet werden. Es können auch Vormischungen verwendet werden, die aus Lösungen der Mischungskomponenten in geeigneten Lösungsmitteln, wobei gegebenenfalls in Lösung homogenisiert wird und das Lösungsmittel anschließend entfernt wird, hergestellt worden sind. Insbesondere können hierbei die weiteren Bestandteile der erfindungsgemäßen Zusammensetzung durch bekannte Verfahren oder als Masterbatch eingebracht werden. Die Verwendung von Masterbatchen ist insbesondere zum Einbringen von Additiven und weiteren Bestandteilen bevorzugt, wobei insbesondere Masterbatche auf Basis der jeweiligen Polymermatrix verwendet werden.

Die erfindungsgemäße Zusammensetzung kann beispielsweise extrudiert werden. Nach der Extrusion kann das Extrudat abgekühlt und zerkleinert werden. Die Zusammenführung und Durchmischung einer Vormischung in der Schmelze kann auch in der Plastifiziereinheit einer Spritzgussmaschine erfolgen. Hierbei wird die Schmelze im anschließenden Schritt direkt in einen Formkörper überführt.

Es hat sich insbesondere herausgestellt, dass die erfindungsgemäße Zusammensetzung besonders geeignet ist für die Herstellung von Extrudaten, bevorzugt für die Extrusion von Profilen und Platten.

Bei dem erfindungsgemäßen Verfahren können die Komponenten A) bis D), wie sie bereits oben näher erläutert wurden, in sämtlichen Bevorzugungen und Kombinationen eingesetzt werden. Bevorzugt dient das erfindungsgemäße Verfahren zur Herstellung der erfindungsgemäßen Zusammensetzung. Die Beschlichtung des Talks oder Talkgemisches B) mit mindestens einem Polycarbonat A) erfolgt in der Schmelze.

Die Substratschicht weist bevorzugt eine Schichtdicke von 0,1 mm bis 6 mm, besonders bevorzugt 0,2 mm bis 4 mm auf.

Die Substratschicht weist erfindungsgemäß eine verbesserte Oberflächenqualität auf. Eine verbesserte Oberflächenqualität im Sinne der Erfindung ist eine Oberfläche, die nur wenige bis keine Störstellen oder Blister und eine glatte Haptik aufweist (geringe Oberflächenrauigkeit, im Mittel weniger als 10 mit dem Auge erkennbare Störstellen auf einer Fläche von 150×105mm²).

In einer Ausführungsform weist das Substratmaterial einen CLTE von <50 ppm/K, bevorzugt <45 ppm/K, besonders bevorzugt <40ppm/K bezogen auf die parallele thermische Ausdehnung nach DIN 53752 (1980-12) und <60, bevorzugt <57, besonders bevorzugt <55 ppm/K bezogen auf die transverse thermische Ausdehnung auf sowie ganz besonders bevorzugt zwischen 20 bis 43 ppm/K (parallel) und 30 bis 56 ppm/K (transversal), insbesondere zwischen 25 bis 38 ppm/K (parallel) und 40 bis 53 ppm/K (transversal).

In einer weiteren Ausführungsform weist das Substratmaterial eine Temperatur- bzw. Wärmeformbeständigkeit > 120°, bevorzugt 130-240°C, besonders bevorzugt 140-220°C, ermittelt nach Vicat B ISO 306, 50K/h auf.

In einer weiteren Ausführungsform weist das Substratmaterial eine Wärmeleitfähigkeit >0.3 W/mK, bevorzugt 0.5-4 W/mK, besonders bevorzugt 0.6-3.5 W/mK bezogen auf die "inplane" Leitfähigkeit nach ASTM 1461, sowie eine "through-plane" Leitfähigkeit nach ASTM 1461 von 0.2 bis 0.5 W/mK auf.

Besonders bevorzugt sind Mehrschichtkörper, die einen Charpy (ungekerbt) >10kJ/m² aufweisen.

### Metallschicht II)

Der erfindungsgemäße Mehrschichtkörper umfasst eine unmittelbar mit der Substratschicht I) verbundene Metallschicht. Dabei umfasst diese Metallschicht bevorzugt mindestens ein Metall, welches ausgewählt wird aus der Gruppe bestehend aus Aluminium, Silber, Chrom, Titan und Palladium. Besonders bevorzugt umfasst die Metallschicht Silber oder Aluminium, insbesondere bevorzugt Aluminium.

Die Schichtdicke der Metallschicht beträgt bevorzugt 10 nm bis 1000 nm, insbesodnere bevorzugt 50 nm bis 800 nm, weiterhin bevorzugt 60 nm bis 500 nm und ganz besonders bevorzugt 60 nm bis 300 nm.

Der Auftrag von Metallen auf die Substratschicht I) kann über verschiedene Methoden wie z.B. durch Aufdampfen oder Sputtern geschehen. Die Verfahren sind näher beschrieben z.B. in "Vakuumbeschichtung Bd.1 bis 5", H. Frey, VDI-Verlag Düsseldorf 1995 oder "Oberflächen- und Dünnschicht-Technologie" Teil 1, R.A. Haefer, Springer Verlag 1987. Bevorzugt wird die Metallschicht aufgedampft oder DC-gesputtert (Kathodenzerstäubung über Gleichspannungsplasma). Diese Verfahren sind dem Fachmann bekannt.

Um eine bessere Metallhaftung zu erreichen und um die Substratoberfläche zu reinigen, werden die Substrate normalerweise einer Plasmavorbehandlung unterzogen. Diese Methoden sind z.B. bei Friedrich et al. in Metallized Plastics 5&6: Fundamental and applied aspects und H. Grünwald et al. In Surface and Coatings Technology 111 (1999) 287-296 beschrieben.

### Schutzschicht III)

Des Weiteren kann der erfindungsgemäße Mehrschichtkörper eine Schutzschicht III) umfassen. Diese ist bevorzugt eine Korrosionsschutzschicht und ist dann bevorzugt vorhanden, wenn die Metallschicht des Mehrschichtformkörper Witterungseinflüssen ausgesetzt ist.

Sie können bevorzugt in einem PECVD (Plasma Enhanced Chemical Vapour Deposition) oder Plasmapolymerisationsprozess aufgebracht werden. Dabei werden niedrigsiedende Precursoren haupsächlich auf Siloxan-Basis in ein Plasma verdampft und dadurch aktiviert, so dass sie einen Film bilden können. Diese Precursoren werden bevorzugt ausgewählt aus der Gruppe, bestehend aus Hexamethyldisiloxan (HMDSO), Octamethylcyclotetrasiloxan (OMCTS), Octamethyltrissiloxan (OMTS), Tetraethylorthosilan (TEOS), und Tetrametyldisiloxan (TMDSO), Decamethylcyclopentasiloxan (DMDMS), Hexamethylcyclotrisiloxan (HMCTS), Trimethoxymethylsilan (TMOMS) und Tetramethylcyclotetrasiloxan (TMCTS).

Die Schichtdicke der Schutzschicht III) beträgt bevorzugt 5 nm bis 200 nm, besonders bevorzugt 10 nm bis 100 nm und ganz besonders bevorzugt 20 bis 50 nm. Die Schutzschicht kann aus einer oder mehreren Schichten bestehen,

### Weitere Schicht(en) IV)

In einer weiteren Ausführungsform kann weiterhin mindestens eine weitere Schicht (IV) enthalten sein. Diese kann sich an beliebiger Stelle im Mehrschichtkörper befinden mit der Ausnahme zwischen den Schichten I) und II), die unmittelbar miteinander verbunden sind.

Bei der mindestens einen weiteren Schicht handelt es sich bevorzugt um eine Schicht, die die Kondensatbildung auf der Oberfläche verhindert (Anti-Fogging Beschichtungen). Sie befindet sich bevorzugt zwischen den Schichten II) und III).

In einer bevorzugten Ausführungsform weist der erfindungsgemäße Mehrschichtkörper eine Schichtdicke der Substratschicht von 0,1 mm bis 6,0 mm, eine Schichtdicke der Metallschicht von 10 nm bis 1000 nm und/oder eine Schichtdicke einer Schutzschicht von 5 nm bis 200 nm auf.

Die erfindungsgemäßen Mehrschichtkörper werden bevorzugt verwendet zur Herstellung von Formteilen wie Reflektoren sowie (Gehäuse-)Bauteilen von Licht- und Wärmequellen und Displays. Formteile sind beispielsweise Lampenfassungen, Lampenabdeckungen, Lichtsammelsysteme, Kollimatoren, weiterhin bedampfte Displays, eine bedampfte Scheibe, eine Linsenhalterung, ein Lichtleiterelement, ein LED-Sockel, ein LED-Reflektor, eine Wärmesenke, ein Kühlelement oder ein Solar-Reflektor und ein Automobilteil. Bei den Automobilteilen handelt es sich bevorzugt um Bezels, Scheinwerfereinhausung und Blinker.

Gegenstand der vorliegenden Erfindung sind daher auch die oben genannten Formteile, umfassend den erfindungsgemäßen Mehrschichtkörper in sämtlichen beschriebenen einzelnen oder kombinierten Ausführungsformen.

### Verfahren

In einem weiteren Aspekt der vorliegenden Erfindung wird ein Verfahren zur Herstellung des erfindungsgemäßen Mehrschichtkörpers bereitgestellt, umfassend die Schritte
(a) Bildung der Substratschicht (I) durch Spritzgießen oder Extrusion der Zusammensetzung, enthaltend die Komponenten A) bis D) und gegebenenfalls weitere Zusatzstoffe, wobei im Spritzguss bevorzugt mit variothermer Werkzeugführung gearbeitet wird,
(b) Aufbringen der Metallschicht (II) auf die in Schritt (a) erhaltene Schicht in einem Plasma-Verfahren und
(c) gegebenenfalls Aufbringen mindestens einer weiteren Schicht (IV),
(d) gegebenenfalls Aufbringen der Schutzschicht (III) auf den in Schritt (b) oder (c) erhaltenen Verbund.

Dabei ist der Schritt (d) bevorzugt so zu verstehen, dass, wenn im Schritt (c) mehrere Schichten aufgebracht werden, dann wird in Schritt (d) die Schutzschicht auf die äußerste Schicht, d.h. die am weitesten von der in Schritt (a) erhaltenen Substratschicht entfernten Schicht, aufgebracht. Bei der Substratschicht des Schritts (a), der Metallschicht des Schritts (b), der optionalen mindestens einen weiteren Schicht des Schritts (c) und der Schutzschicht des Schritts (d) handelt es sich jeweils um die Schichten I) bis IV), wie oben näher erläutert.

### Verwendung

In einem weiteren Aspekt betrifft die vorliegende Erfindung die Verwendung mindestens eines anhydridmodifiziertes alpha-Olefin-Polymers C) mit einer Säurezahl von mindestens 30 mg KOH/g und einem mittleren Molekulargewicht Mw von 4000 bis 25000 g/mol, wobei das mittlere Molekulargewicht Mw bestimmt wird mittels Gelpermeationschromatographie in ortho-Dichlorbenzol bei 150 °C mit Polystyrolkalibrierung zur Herstellung einer Substratschicht eines Mehrschichtkörpers,
wobei der Mehrschichtkörper mindestens die eine Substratschicht, eine hiermit unmittelbar verbundene Metallschicht und wenigstens eine auf der Metallschicht aufliegende Schutzschicht umfasst, und
wobei die Substratschicht eine Zusammensetzung umfasst, welche erhalten wird durch Vermischen zumindest der Komponenten A) bis D), wobei
   A) mindestens ein Polycarbonat ist und
   B) mindestens eine Art von Talk ist.

Wie oben bereits näher erläutert, kann erfindungsgemäß durch die Verwendung der erfindungsgemäßen Komponente C) in sämtlichen oben beschriebenen Bevorzugungen der Abbau des Polycarbonats A) durch die Komponente B) effektiv reduziert werden. So können Substratschichten für Mehrschichtenkörper erhalten werden, welche besonders gute Temperatur- bzw. Wärmeformbeständigkeit und gleichzeitig eine verbesserte Oberflächenqualität, gute Metallhaftung, sowie hervorragende Dimensionsstabilität (CLTE) aufweisen.

Diese Effekte können insbesondere erzielt werden, wenn die Mengen von B) und C) vor der Vermischung so aufeinander abgestimmt sind, dass pro 10 Gewichtsteile der Komponente B) die oben genannten Gewichtsteile der Komponente C) eingesetzt werden.

Ebenso ist es aus den bereits erläuterten Gründen besonders bevorzugt, dass das Talk oder Talkgemisch der Komponente B) unbeschlichtet ist. Ebenso ist es bevorzugt, dass das Talk oder Talkgemisch der Komponente B) einen pH-Wert von 8 bis 10 aufweist, wobei der pH-Wert des Talks oder des Talkgemisches bestimmt wird gemäß EN ISO 787-9:1995.

### Beispiele

Verwendete Materialien:
PC1: ein lineares Bisphenol-A-Polycarbonat mit einem einem mittleren Molekulargewicht Mw von ca. 31.000 g/mol der Covestro Deutschland AG und einer Erweichungstemperatur (VST/B 120 nach ISO 306:2014-3) von 150°C, welches keinen UV-Absorber enthält. Die Schmelze-Volumenfließrate (MVR) nach ISO 1133:2012-03 beträgt 6,0 cm³/(10 min) bei 300 °C und 1,2 kg Belastung.
PC2: ein kommerziell erhältliches Copolycarbonat auf Basis von Bisphenol A und Bisphenol TMC der Covestro Deutschland AG mit einem MVR von 18 cm³/10 min bei 330°C und 2,16 kg Belastung und einer Erweichungstemperatur (VST/B 120 nach ISO 306:2014-3) von 183°C.
PC3: ein lineares Bisphenol-A-Polycarbonat mit einem mittleren Molekulargewicht Mw von ca. 24.000 g/mol der Covestro Deutschland AG und einer Erweichungstemperatur (VST/B 120 nach ISO 306:2014-3) von 148°C, welches keinen UV-Absorber enthält.. Die Schmelze-Volumenfließrate (MVR) nach ISO 1133:2012-03 beträgt 19,0 cm³/(10 min) bei 300 °C und 1,2 kg Belastung.
B1 (erfindungsgemäß): Kompaktierter unbeschlichteter Talk mit einem Talkgehalt von 99 Gew.-%, einem Eisenoxidgehalt von 0,4 Gew.-%, einem Aluminiumoxidgehalt von 0,4 Gew.-%, Glühverlust von 6,0 Gew.-%, pH-Wert (nach EN ISO 787-9:1995) von 9,55, D50 (Sedimentationsanalyse nach ISO 13317-3:2001) von 0,65 µm; BET-Oberfläche 13,5 m²/g, Typ: HTP Ultra5c, Hersteller: Imifabi.
B2 (erfindungsgemäß): Kompaktierter unbeschlichteter Talk mit einem Talkgehalt von 98 Gew.-%, einem Eisenoxidgehalt von 1,9 Gew.-%, einem Aluminiumoxidgehalt von 0,2 Gew.-%, Glühverlust (DIN 51081/1000 °C) von 5,4 Gew.-%, pH-Wert (nach EN ISO 787-9:1995) von 9,15, D50 (Sedimentationsanalyse nach ISO 13317-3:2001) von 2,2 µm; BET-Oberfläche nach ISO 4652:2012) 10 m²/g, Typ: Finntalc M05SLC, Hersteller: Mondo Minerals B. V.
B3 (Vergleich): Nicht kompaktierter unbeschlichteter Talk mit einem Talkgehalt von 98 Gew.-%, einem Eisenoxidgehalt von 2,0 Gew.-%, einem Aluminiumoxidgehalt von 0,2 Gew.-%, Glühverlust (DIN 51081/1000 °C) von 5,4 Gew.-%, pH-Wert (nach EN ISO 787-9:1995) von 9,1, D50 (Sedimentationsanalyse nach ISO 13317-3:2001) von 10 µm; BET-Oberfläche nach ISO 4652:2012) 3,5 m2/g, Typ: Finntalc M30SL, Hersteller: Mondo Minerals B. V.
C1: Ethylen-Propylen-Octen-Terpolymer mit Maleinsäureanhydrid (Ethylen:Propylen:Octen 87:6:7 (Gewichtsverhältnis)), CAS-Nr. 31069-12-2, mit Molekulargewicht (Gelpermeationschromatographie in ortho-Dichlorbenzol bei 150 °C mit Polystyrolkalibrierung) Mw = 6.301 g/mol, Mn = 1159 g/mol, Dichte 940 kg/m³, Säurezahl 53 mg KOH/g, Maleinsäureanhydridanteil 4,4 Gew.-%, bezogen auf das Terpolymer C1.
C2: Propylen-Maleinsäureanhydrid-Polymer mit einem mittleren Molekulargewicht (Gelpermeationschromatographie in ortho-Dichlorbenzol bei 150 °C mit Polystyrolkalibrierung) Mw = 20700 g/mol, Mn = 1460 g/mol, Säurezahl 78 mg KOH/g.E: Titandioxid, beschlichtetes Titandioxid, Typ: Kronos^{®} 2230, Hersteller:Kronos Titan GmbH, Deutschland.
D1 (erfindungsgemäß): hochkristallines Bornitrid-Pulver (Mix aus Plättchen und Agglomeraten) mit einem D50 von 16 µm (Laserbeugung nach ISO 13320:2009); BET-Oberfläche (nach ISO 4652:2012) von 8,0 m²/g, Typ: CF600 Hersteller: Momentive Performance Materials Inc.
D2 (Vergleich): hochleitfähiges expandiertes Graphitpulver mit einem D50 ≥800µm und einem Carbongehalt ≥98%, Typ: Sigratherm^{®} GFG 900, Hersteller: SGL CARBON GmbH.
D3 (erfindungsgemäß): kompaktierter expandierter Graphit (Pulver) mit einem D50 von 38µm (Laserbeugung nach ISO 13320:2009), einem Carbongehalt ≥99%, einer BET-Oberfläche (nach ISO 9277:2010) von 25,0 m²/g, Typ: TIMREX^{®} C-Therm001, Hersteller: Imerys Graphite & Carbon Switzerland Ltd.
F: übliche Additive wie Thermostabilisatoren, in den Beispielen Irganox^{®} B 900 der BASF Lampertheim GmbH.

Die Säurezahlen der Komponenten C1 und C2 wurden nach DIN ISO 17025:2005 von der Firma Currenta GmbH u. Co. OHG, Leverkusen, über potentiometrische Titration mit alkoholischer Kaliumhydroxid-Lösung bestimmt.

Die Bestimmung der Schmelze-Volumenfließrate (MVR) erfolgte nach ISO 1133-1:2012 bei einer Prüftemperatur von 300 °C, Masse 1,2 kg oder 330 °C und 2,16 kg mit dem Gerät Zwick 4106 der Firma Zwick Roell. Dabei steht die Abkürzung MVR für die Anfangs-Schmelze-Volumenfließrate (nach 4 Minuten Vorwärmzeit),

Die Schlagzähigkeit nach Charpy wurde nach ISO 179/1eU (Version von 2010) an einseitig angespritzten Prüfstäben der Dimension 80 mm × 10 mm × 4 mm bei 23 °C gemessen.

Die Vicat-Erweichungstemperatur VST/B50 bzw. VST/B120 als Maß für die Temperatur- bzw. Wärmeformbeständigkeit wurde gemäß ISO 306 (Version von 2014) an Prüfkörpern der Abmessung 80 mm × 10 mm × 4 mm mit einer Stempellast von 50 N und einer Aufheizgeschwindigkeit von 50°C/h oder 120°C/h mit dem Gerät Coesfeld Eco 2920 der Firma Coesfeld Materialtest bestimmt.

Die Wärmeleitfähigkeit wurde an spritzgegossenen Prüfkörpern mit den Abmaßen 60×60×2mm³ gemäß ASTM E 1461 (Version von 2013, Nano Flash Methode) bestimmt.

Der lineare Wärmeausdehnungskoeffizient (CLTE) wurde an einem spritzgegossenen Prüfkörper mit den Dimensionen 10×10×4mm³ gemäß DIN 53752 (1980-12) mit einem Gerät des Typs Mettler Toledo TMA/SDTA 1+ bestimmt.

Die Oberflächenqualität wurde an spritzgegossenen Teilen mit den Dimensionen 150×105×3mm³ visuell bestimmt. Dabei wurde die Oberfläche der Probekörper als schlecht bewertet, die im Mittel auf der Oberfläche der Probekörper (150×105mm²) mehr als 10 mit dem Auge deutlich erkennbare Störstellen (Erhebungen, "Pickel" oder "Blister", Vertiefungen, Agglomerate) aufwiesen.

Die Scherviskositäten bzw. Schmelzeviskositäten wurden nach ISO 11443 Methode A2 bei einer Temperatur von 300°C mit einem Gerät des Typs VISCORobo der Firma Göttfert Werkstoff-Prüfmaschinen GmbH ermittelt.

**Tabelle 1:**

| **Komponenten** / **Beispiel** | | | **V1** | **1** | **2** | **3** | **V2** | **4** | **5** | **6** | **V3** | **7** | **V4** |
|---|---|---|---|---|---|---|---|---|---|---|---|---|---|
| **PC1** | | | | | | | | | | | | | |
| **PC2** | | | | | | | | | | | | | |
| **PC3** | | | 89,50 | 79,00 | 68,50 | 58,00 | 47,50 | 74,00 | 69,00 | 79,00 | 69,00 | 66,50 | 66,50 |
| **B1** | | | | | | | | | | | | | |
| **B2** | | | 10,00 | 20,00 | 30,00 | 40,00 | 50,00 | 20,00 | 20,00 | 10,00 | 10,00 | 30,00 | |
| **B3** | | | | | | | | | | | | | 30,00 |
| **C1** | | | 0,50 | 1,00 | 1,50 | 2,00 | 2,50 | 1,00 | 1,00 | 1,00 | 1,00 | 1,50 | 1,50 |
| **C2** | | | | | | | | | | | | | |
| **D1** | | | | | | | | 5,00 | 10,00 | 10,00 | 20,00 | | |
| **D2** | | | | | | | | | | | | | |
| **D3** | | | | | | | | | | | | | |
| **E** | | | | | | | | | | | | 2,00 | 2,00 |
| **F** | | | | | | | | | | | | | |

| **optische Beurteilung eines 150×105×3mm³ Spritzugusskörpers** | | | **gut** | **gut** | **gut** | **gut** | **schlecht** | **gut** | **gut** | **gut** | **schlecht** | **gut** | **schlecht** |
|---|---|---|---|---|---|---|---|---|---|---|---|---|---|
| **Schmelzeviskosität nach ISO 11443 bei 300°C** | **[s⁻¹]** | | | | | | | | | | | | |
| | 50 | Pas | 248 | 261 | 324 | 385 | 245 | 316 | 370 | 363 | 500 | 326 | 456 |
| | 100 | Pas | 249 | 247 | 295 | 339 | 186 | 302 | 340 | 347 | 447 | 292 | 404 |
| | 200 | Pas | 242 | 221 | 256 | 294 | 154 | 276 | 306 | 320 | 402 | 261 | 350 |
| | 500 | Pas | 211 | 183 | 186 | 225 | 120 | 227 | 246 | 267 | 315 | 210 | 270 |
| | **1000** | **Pas** | **177** | **157** | **149** | **172** | **98** | **183** | **195** | **216** | **248** | **168** | **209** |
| | 1500 | Pas | 159 | 141 | 133 | 146 | 85 | 158 | 168 | 185 | 209 | 146 | 176 |
| | 5000 | Pas | 96 | 90 | 84 | 80 | 54 | 89 | 93 | 101 | 112 | 83 | 98 |

| **Tabelle 1 Fortsetzung** | | | | | | | | | | | | | |
|---|---|---|---|---|---|---|---|---|---|---|---|---|---|
| **Charpy Schlagversuch nach ISO179** / **1eU** | **23°C** | kJ/m² | **249** | **171** | **84** | **20** | **8** | **43** | **33** | **54** | **27** | **78** | **35** |
| | | | | | | | | | | | | | |
| **VICAT B nach ISO 306 mit 50K/h** | 50 K/h | °C | 143,9 | **143,4** | **144,0** | **143,3** | **142,9** | **145,4** | **146,0** | **146,2** | **146,7** | **144,4** | 144,2 |
| **Wärmeleitfähigkeit nach ASTM E 1461 bei 23°C** | **in-plane** | W/mK | **0,34** | **0,56** | **0,97** | **1,37** | **1,83** | **0,84** | **1,20** | **0,82** | **1,65** | **0,91** | **0,94** |
| | **through-plane** | W/mK | **0,22** | **0,23** | **0,25** | **0,28** | **0,32** | **0,30** | **0,30** | **0,28** | **0,38** | **0,23** | **0,25** |
| | | | | | | | | | | | | | |
| **Linearer Wärmeausdehnungskoeffizient (CLTE) nach DIN 53752** | **parallel** | ppm/K | **51,7** | **42,0** | **36,9** | **30,8** | **34,8** | **39,4** | **36,6** | **42,8** | **34,1** | **35,2** | **37,5** |
| | **transverse** | ppm/K | **59,2** | **55,5** | **52,1** | **52,2** | **43,4** | **53,8** | **52,9** | **56,3** | **49,4** | **54,0** | **54,0** |

**Tabelle 2 wie folgt:**

| **Komponenten** / **Beispiel** | | | **8** | **9** | **V5** | **10** | **V6** | **11** | **12** | **V7** | **V8** | **V9** | **V10** |
|---|---|---|---|---|---|---|---|---|---|---|---|---|---|
| **PC1** | | | | | | | | 71,8 | 8,8 | | | | |
| **PC2** | | | | | | | | | 63,0 | | | | |
| **PC3** | | | 78,8 | 73,8 | 73,8 | 71,8 | 71,8 | | | 68,8 | 68,8 | 88,8 | 88,8 |
| **B1** | | | 20,0 | 20,0 | 20,0 | 20,0 | 20,0 | 20,0 | 20,0 | 20,0 | 20,0 | | |
| **B2** | | | | | | | | | | | | | |
| **B3** | | | | | | | | | | | | | |
| **C1** | | | | | | | | | | | | | |
| **C2** | | | 1,0 | 1,0 | 1,0 | 1,0 | 1,0 | 1,0 | 1,0 | 1,0 | 1,0 | 1,0 | 1,0 |
| **D1** | | | | | | | | | | | | | |
| **D2** | | | | | 5,0 | | 7,0 | | | 10,0 | | 10,0 | |
| **D3** | | | | 5,0 | | 7,0 | | 7,0 | 7,0 | | 10,0 | | 10,0 |
| **E** | | | | | | | | | | | | | |
| **F** | | | 0,2 | 0,2 | 0,2 | 0,2 | 0,2 | 0,2 | 0,2 | 0,2 | 0,2 | 0,2 | 0,2 |
| | | | | | | | | | | | | | |

| **optische Beurteilung eines 150×105×3mm³ Spritzugusskörpe**rs | | | **gut** | **gut** | **schlecht** | **gut** | **schlecht** | **gut** | **gut** | **schlecht** | **schlecht** | **schlecht** | **schlecht** |
|---|---|---|---|---|---|---|---|---|---|---|---|---|---|
| **Schmelzeviskosität nach ISO 11443 bei 300°C** | **[s⁻¹]** | | | | | | | | | | | | |
| | 50 | Pas | 244 | 442 | 460 | 571 | 533 | 1165 | 1179 | 625 | 707 | 496 | 668 |
| | 100 | Pas | 228 | 369 | 397 | 469 | 442 | 884 | 983 | 476 | 549 | 429 | 602 |
| | 200 | Pas | 218 | 305 | 332 | 378 | 363 | 691 | 772 | 380 | 424 | 362 | 507 |
| | 500 | Pas | 185 | 230 | 256 | 279 | 273 | 494 | 563 | 277 | 309 | 285 | 368 |
| | **1000** | **Pas** | **154** | **182** | **203** | **216** | **213** | **373** | **418** | **215** | **237** | **222** | **273** |
| | 1500 | Pas | 138 | 157 | 175 | 183 | 182 | 309 | 349 | 183 | 200 | 186 | 229 |
| | 5000 | Pas | 82 | 89 | 98 | 100 | 100 | 149 | 169 | 100 | 108 | 107 | 123 |

| **Tabelle 2 Fortsetzung** | | | | | | | | | | | | | |
|---|---|---|---|---|---|---|---|---|---|---|---|---|---|
| **Charpy Schlagversuch nach ISO179** / **1eU** | **23°C** | kJ/m² | **138** | **24** | **20** | **22** | **18** | **16** | **13** | **13** | **14** | **25** | **33** |
| | | | | | | | | | | | | | |
| **VICAT B nach ISO 306 mit 50K/h** | **50 K/h** | °C | **144,0** | **145,1** | **145,0** | **145,9** | **145,0** | **143,5** | **172,1** | **145,2** | **146,2** | **144,5** | **146,0** |
| **Wärmeleitfähigkeit nach ASTM E 1461 bei 23°C** | **in-plane** | W/mK | **0,61** | **1,52** | **1,53** | **1,93** | **2,03** | **2,64** | **2,16** | **3,52** | **3,39** | **1,47** | **1,21** |
| | **through-plane** | W/mK | **0,22** | **0,33** | **0,33** | **0,34** | **0,35** | **0,35** | **0,31** | **0,46** | **0,45** | **0,39** | **0,40** |
| | | | | | | | | | | | | | |
| **Linearer Wärmeausdehnungskoeffizient (CLTE) nach DIN** 53752 | **parallel** | ppm/K | **43,6** | **39,0** | **43,3** | **38,4** | **40,1** | **34,8** | **34,5** | **35,4** | **30,3** | **56,2** | **53,0** |
| | **transverse** | ppm/K | **59,6** | **54,2** | **54,8** | **53,7** | **53,8** | **51,5** | **50,5** | **50,0** | **51,3** | **61,5** | **62,1** |

| | | | | | | | | | | | | | |
|---|---|---|---|---|---|---|---|---|---|---|---|---|---|
| V = Vergleich | | | | | | | | | | | | | |

Aus den Beispielen der Tabelle 1 und 2 geht hervor, dass die erfindungsgemäßen Beispiele bei vergleichbarer oder besserer Wärmeformbeständigkeit eine verbesserte Dimensionsstabilität (CLTE), eine gute Schlagzähigkeit und eine bessere Oberflächenqualität als die Vergleichsbeispiele aufweisen (Beispiele 1, 2 und 3 gegen V1 und V2). Zudem wurde überraschend eine deutlich verbesserte Wärmeleitfähigkeit für die Beispiele 1, 2 und 3 gegenüber V1 gefunden. Wird ein zu geringer Gehalt an Komponente B gewählt, ist die Dimensionsstabilität nicht ausreichend (V1), ein zu hoher Gehalt an Komponente B beeinflusst die Oberflächenqualität und Schlagzähigkeit negativ (V2). Wird ein Teil der Komponente B durch die optionale Komponente D1 (Bornitrid) ersetzt, können Wärmeformbeständigkeit, Dimensionsstabilität (CLTE), Schlagzähigkeit und Oberflächenqualität optimiert werden, allerdings darf die Menge an D1 nicht zu hoch gewählt sein, da sonst die Oberflächenqualität negativ beeinflusst wird (Beispiele 4, 5 und 6 gegen V3). Die verbesserten Eigenschaften von Beispiel 2 können auch beibehalten werden, wenn zusätzlich noch ein Pigment E zugesetzt wird (Beispiel 7), jedoch verschlechtern sich bei Verwendung der nicht erfindungsgemäßen Komponente B3 an Stelle von B2 wichtige Eigenschaften wie Oberflächenqualität und Schlagzähigkeit (7 gegen V4).

Wird ein Teil der Komponente B durch die optionale Komponente D2 oder D3 (expandierter Graphit) ersetzt, so können Dimensionsstabilität (CLTE) und Wärmeleitfähigkeit noch weiter verbessert werden (Beispiele 8 und 9), jedoch resultiert nur dann eine gute Oberflächenqualität, wenn der erfindungsgemäße Graphit D3 verwendet wird. Bei Verwendung des nicht erfindungsgemäßen Graphits D2 ist die Oberflächenqualität unabhängig von der Konzentration an D2 schlecht. Zudem zeigt der erfindungsgemäße Graphit D3 Vorteile bei Schlagzähigkeit und Dimensionsstabilität gegenüber D2 (Beispiel 9 gegen V5, 10 gegen V6).

Wie die Beispiele 11 und 12 zeigen kann die Verbesserung der Dimensionsstabilität von Beispiel 10 bei gleichzeitig hoher oder verbesserter Wärmeformbeständigkeit auch in anderen Polycarbonaten (PC1) und Copolycarbonaten (PC2) herbeigeführt werden. Hier zeigt vor allem die Verwendung von PC1 in Beispiel 11 eine überraschend starke Verbesserung der Wärmeleitfähigkeit, die der Fachmann so nicht hätte erwarten können.

Wie die Vergleichsbeispiele V7, V8, V9 und V10 zeigen, darf die Konzentration an erfindungsgemäßer Komponente D3 nicht zu hoch gewählt werden, da ansonsten eine schlechte Oberflächenqualität resultiert wie es generell bei Verwendung der nicht erfindungsgemäßen Komponente D2 der Fall ist.

Alle erfindungsgemäßen Beispiele weisen trotz des hohen Füllstoffgehaltes eine gute Schlagzähigkeit nach IS0179 / 1eU sowie eine gute Verarbeitbarkeit in Spritzgussverfahren auf, was an den Schmelzeviskositätsverläufen erkennbar ist.

## Patentansprüche

1. Ein Mehrschichtkörper, welcher
I) eine Substratschicht (S),
II) eine hiermit unmittelbar verbundene Metallschicht (M) und
III) gegebenenfalls eine auf der Metallschicht aufliegende Schutzschicht (P) umfasst,
wobei die Substratschicht eine Zusammensetzung umfasst, erhältlich durch Vermischen der Komponenten A) bis D), wobei
A) ein Polycarbonat ist,
B) ein unbeschlichteter Talk mit einem mittleren Partikeldurchmesser D50 von 0,01 bis 9,5 µm ist, wobei der Partikeldurchmesser D50 bestimmt wird durch Sedimentationsanalyse,
C) mindestens ein anhydridmodifiziertes alpha-Olefin-Polymer mit einer Säurezahl von mindestens 30 mg KOH/g, bestimmt mittels potentiometrischer Titration mit alkoholischer Kaliumhydroxid-Lösung gemäß DIN ISO 17025:2005, und einem mittleren Molekulargewicht MW von 4.000 bis 40.000 g/mol ist, wobei das mittlere Molekulargewicht MW bestimmt wird mittels Gelpermeationschromatographie in ortho-Dichlorbenzol bei 150 °C mit Polystyrolkalibrierung,
sowie
optional D) ein Teil der Menge an Komponente B) durch mindestens einen weiteren Füllstoff ausgewählt aus der Gruppe bestehend aus
a) einem expandierten Graphit mit einem Teilchendurchmesser D50 von kleiner 800 µm,
b) eine Mischung aus dem vorgenannten expandiertem Graphit mit nicht expandiertem Graphit,
c) eine Mischung aus dem vorgenannten expandiertem Graphit mit nicht expandiertem Graphit und Bornitrid
d) eine Mischung aus dem vorgenannten expandiertem Graphit und Bornitrid
als weiterer Füllstoff ersetzt werden kann, wobei im Falle des Graphits bis zu 8 Gew.-Teile der Menge an Komponente B) ersetzt werden können und wobei im Falle des Bornitrids bis zu 15 Gew.-Teile der Menge an Komponente B) ersetzt werden können,
wobei die Mengen der Komponenten B) und C) vor der Vermischung mit Komponente C) so aufeinander abgestimmt sind, dass pro 10 Gewichtsteile der Komponente B) 0,10 bis 1,4 Gewichtsteile der Komponente C) eingesetzt werden und wobei die Zusammensetzung frei ist von Pfropfpolymerisaten und Polyestern.

2. Mehrschichtkörper nach Anspruch 1, wobei die Menge von B) 12 bis 45 Gew.-% bezogen auf die Gesamtzusammensetzung beträgt.

3. Mehrschichtkörper nach einem der Ansprüche 1 oder 2, wobei die Menge von B) 18 bis 35 Gew.-% bezogen auf die Gesamtzusammensetzung beträgt.

4. Mehrschichtkörper nach einem der Ansprüche 1 bis 3, wobei die Mengen von B) und C) vor der Vermischung so aufeinander abgestimmt sind, dass pro 10 Gewichtsteile der Komponente B) 0,25 bis 1,4 Gewichtsteile der Komponente C) eingesetzt werden.

5. Mehrschichtkörper nach einem der Ansprüche 1 bis 4, wobei der Talk oder das Talkgemisch der Komponente B) einen pH-Wert von 8 bis 10 aufweist, wobei der pH-Wert des Talks oder des Talkgemisches bestimmt wird gemäß EN ISO 787-9:1995.

6. Mehrschichtkörper nach einem der Ansprüche 1 bis 5, wobei die Komponente B) einen mittleren Partikeldurchmesser D50 von 0,5 bis 3,0 µm aufweist, wobei der Partikeldurchmesser D50 bestimmt wird durch Sedimentationsanalyse.

7. Mehrschichtkörper nach einem der Ansprüche 1 bis 6, wobei die Komponente B) eine BET-Oberfläche von 7,5 bis 20,0 m²/g aufweist.

8. Mehrschichtkörper nach einem der Ansprüche 1 bis 7, wobei die Substratschicht eine Dicke von 0,1 mm bis 6,0 mm, die Metallschicht eine Dicke von 10 nm bis 1000 nm und die optionale Schutzschicht eine Dicke von 5 nm bis 200 nm aufweist.

9. Mehrschichtkörper nach einem der Ansprüche 1 bis 8, wobei die Metallschicht mindestens ein Metall, welches ausgewählt ist aus der Gruppe, bestehend aus Aluminium, Silber, Chrom, Titan und Palladium, umfasst.

10. Mehrschichtkörper nach einem der Ansprüche 1 bis 9, wobei die Metallschicht Silber oder Aluminium umfasst.

11. Mehrschichtkörper nach einem der Ansprüche 1 bis 10, wobei im Falle, dass Graphit als Komponente D) anwesend ist, 2 bis 7 Gew.-Teile der Menge an Komponente B) ersetzt werden und wobei im Falle, dass Bornitrid als Komponente D) anwesend ist, 2 bis 12 Gew.-Teile der Menge an Komponente B) ersetzt werden.

12. Reflektoren sowie Bauteile von Licht- und Wärmequellen, umfassend den Mehrschichtkörper nach einem der Ansprüche 1 bis 11.

13. Verfahren zur Herstellung eines Mehrschichtkörpers nach einem der Ansprüche 1 bis 11, umfassend die Schritte
(a) Bildung der Substratschicht durch Spritzgießen oder Extrusion der Zusammensetzung, mindestens enthaltend die Komponenten A) bis C), optional enthaltend die Komponente D),
(b) Aufbringen der Metallschicht auf die in Schritt (a) erhaltene Schicht in einem Plasma-Verfahren und
(c) gegebenenfalls Aufbringen mindestens einer weiteren Schicht, sowie
(d) gegebenenfalls Aufbringen der Schutzschicht auf die in Schritt (b) oder (c) erhaltene Schicht.

14. Verwendung mindestens eines anhydridmodifizierten alpha-Olefin-Polymers C) mit einer Säurezahl von mindestens 30 mg KOH/g und einem mittleren Molekulargewicht M_{W} von 4000 bis 25000 g/mol, wobei das mittlere Molekulargewicht M_{W} bestimmt wird mittels Gelpermeationschromatographie in ortho-Dichlorbenzol bei 150 °C mit Polystyrolkalibrierung zur Herstellung einer Substratschicht eines Mehrschichtkörpers,
wobei der Mehrschichtkörper mindestens die eine Substratschicht, eine hiermit unmittelbar verbundene Metallschicht und gegebenenfalls wenigstens eine auf der Metallschicht aufliegende Schicht umfasst, und
wobei die Substratschicht eine Zusammensetzung umfasst, welche erhalten wird durch Vermischen zumindest der Komponenten A) bis D), wobei
A) ein Polycarbonat ist und
B) ein unbeschlichteter Talk ist,
sowie
optional D) ein Teil der Menge an Komponente B) durch mindestens einen weiteren Füllstoff ausgewählt aus der Gruppe bestehend aus
a) einem expandierten Graphit mit einem Teilchendurchmesser D50 von kleiner 800 µm,
b) eine Mischung aus dem vorgenannten expandiertem Graphit mit nicht expandiertem Graphit,
c) eine Mischung aus dem vorgenannten expandiertem Graphit mit nicht expandiertem Graphit und Bornitrid
d) eine Mischung aus dem vorgenannten expandiertem Graphit und Bornitrid oder
als weiterer Füllstoff ersetzt werden kann.

15. Verwendung nach Anspruch 14, wobei die Mengen von B) und C) vor der Vermischung so aufeinander abgestimmt sind, dass pro 10 Gewichtsteile der Komponente B) 0,25 bis 1,4 Gewichtsteile der Komponente C) eingesetzt werden.

## Claims

1. Multilayer body comprising
I) a substrate layer (S),
II) a metal layer (M) bonded directly thereto and
III) optionally a protective layer (P) atop the metal layer,
wherein the substrate layer comprises a composition obtainable by mixing components A) to D), wherein
A) is a polycarbonate,
B) is an unsized talc having a median particle diameter D50 of 0.01 to 9.5 µm, where the particle diameter D50 is determined by sedimentation analysis,
C) is at least one anhydride-modified alpha-olefin polymer having an acid number of at least 30 mg KOH/g, determined by means of potentiometric titration with alcoholic potassium hydroxide solution according to DIN ISO 17025:2005, and an average molecular weight MW of 4000 to 40 000 g/mol, where the average molecular weight MW is determined by means of gel permeation chromatography in ortho-dichlorobenzene at 150°C with polystyrene calibration,
and
optionally D) a portion of the amount of component B) may be replaced by at least one further filler selected from the group consisting of
a) an expanded graphite having a particle diameter D50 of less than 800 µm,
b) a mixture of the aforementioned expanded graphite with unexpanded graphite,
c) a mixture of the aforementioned expanded graphite with unexpanded graphite and boron nitride,
d) a mixture of the aforementioned expanded graphite and boron nitride
as further filler, where, in the case of graphite, up to 8 parts by weight of the amount of component B) may be replaced and where, in the case of boron nitride, up to 15 parts by weight of the amount of component B) may be replaced,
wherein the amounts of components B) and C) prior to mixing with component C) are matched to one another such that, for every 10 parts by weight of component B), 0.10 to 1.4 parts by weight of component C) are used, and wherein the composition is free of graft polymers and polyesters.

2. Multilayer body according to Claim 1, wherein the amount of B) is 12% to 45% by weight, based on the overall composition.

3. Multilayer body according to either of Claims 1 and 2, wherein the amount of B) is 18% to 35% by weight, based on the overall composition.

4. Multilayer body according to any of Claims 1 to 3, wherein the amounts of B) and C) prior to mixing are matched to one another such that, for every 10 parts by weight of component B), 0.25 to 1.4 parts by weight of component C) are used.

5. Multilayer body according to any of Claims 1 to 4, wherein the talc or talc mixture of component B) has a pH of 8 to 10, wherein the pH of the talc or talc mixture is determined according to EN ISO 787-9:1995.

6. Multilayer body according to any of Claims 1 to 5, wherein component B) has a median particle diameter D50 of 0.5 to 3.0 µm, wherein the particle diameter D50 is determined by sedimentation analysis.

7. Multilayer body according to any of Claims 1 to 6, wherein component B) has a BET surface area of 7.5 to 20.0 m²/g.

8. Multilayer body according to any of Claims 1 to 7, wherein the substrate layer has a thickness of 0.1 mm to 6.0 mm, the metal layer a thickness of 10 nm to 1000 nm, and the optional protective layer a thickness of 5 nm to 200 nm.

9. Multilayer body according to any of Claims 1 to 8, wherein the metal layer comprises at least one metal which is selected from the group consisting of aluminium, silver, chromium, titanium and palladium.

10. Multilayer body according to any of Claims 1 to 9, wherein the metal layer comprises silver or aluminium.

11. Multilayer body according to any of Claims 1 to 10, wherein, in the case that graphite is present as component D), 2 to 7 parts by weight of the amount of component B) are replaced, and wherein, in the case that boron nitride is present as component D), 2 to 12 parts by weight of the amount of component B) are replaced.

12. Reflectors and components of light sources and heat sources comprising the multilayer body according to any of Claims 1 to 11.

13. Process for producing a multilayer body according to any of Claims 1 to 11, comprising the steps of
(a) forming the substrate layer by injection moulding or extrusion of the composition, at least comprising components A) to C), optionally comprising component D),
(b) applying the metal layer to the layer obtained in step (a) in a plasma process and
(c) optionally applying at least one further layer, and
(d) optionally applying the protective layer to the layer obtained in step (b) or (c).

14. Use of at least one anhydride-modified alpha-olefin polymer C) having an acid number of at least 30 mg KOH/g and an average molecular weight M_{w} of 4000 to 25 000 g/mol, wherein the average molecular weight M_{w} is determined by means of gel permeation chromatography in ortho-dichlorobenzene at 150°C with polystyrene calibration, for production of a substrate layer of a multilayer body,
wherein the multilayer body comprises at least the one substrate layer, a metal layer bonded directly thereto and optionally at least one layer atop the metal layer, and
wherein the substrate layer comprises a composition which is obtained by mixing at least components A) to D), wherein
A) is a polycarbonate and
B) is an unsized talc,
and
optionally D) a portion of the amount of component B) may be replaced by at least one further filler selected from the group consisting of
a) an expanded graphite having a particle diameter D50 of less than 800 µm,
b) a mixture of the aforementioned expanded graphite with unexpanded graphite,
c) a mixture of the aforementioned expanded graphite with unexpanded graphite and boron nitride,
d) a mixture of the aforementioned expanded graphite and boron nitride or
as further filler.

15. Use according to Claim 14, wherein the amounts of B) and C) prior to mixing are matched to one another such that, for every 10 parts by weight of component B), 0.25 to 1.4 parts by weight of component C) are used.

## Revendications

1. Corps multicouche, qui comprend
I) une couche de substrat (S),
II) une couche métallique (M) directement reliée à celle-ci et
III) le cas échéant une couche de protection (P) appliquée sur la couche métallique,
la couche de substrat comprenant une composition pouvant être obtenue par mélange des composants A) à D),
A) étant un polycarbonate,
B) étant un talc non revêtu présentant un diamètre moyen de particule D50 de 0,01 à 9,5 µm, le diamètre moyen de particule D50 étant déterminé par analyse par sédimentation,
C) au moins polymère alpha-oléfinique modifié par anhydride présentant un indice d'acide d'au moins 30 mg de KOH/g, déterminé par titrage potentiométrique à l'aide d'une solution alcoolique d'hydroxyde de potassium selon la norme DIN ISO 17025:2005 et présentant un poids moléculaire moyen MW de 4000 à 40.000 g/mole, le poids moléculaire moyen MW étant déterminé par chromatographie par perméation de gel dans de l'ortho-dichlorobenzène à 150°C à l'aide d'un étalonnage au polystyrène,
ainsi que, éventuellement, D) une partie de la quantité de composants B) pouvant être remplacée, comme autre charge, par au moins une autre charge choisie dans le groupe constitué par
a) un graphite expansé présentant un diamètre de particule D50 inférieur à 800 µm,
b) un mélange du graphite expansé susmentionné avec du graphite non expansé,
c) un mélange du graphite expansé susmentionné avec du graphite non expansé et du nitrure de bore,
d) un mélange du graphite expansé susmentionné avec du nitrure de bore,
où, dans le cas du graphite, jusqu'à 8 parties en poids de la quantité de composant B) peuvent être remplacées et où, dans le cas du nitrure de bore, jusqu'à 15 parties en poids de la quantité de composants B) peuvent être remplacées, les quantités des composants B) et C) étant adaptées l'une à l'autre avant le mélange avec le composant C) de manière telle qu'on utilise, par 10 parties en poids du composant B), 0,10 à 1,4 partie en poids du composant C) et la composition étant exempte de polymères greffés et de polyesters.

2. Corps multicouche selon la revendication 1, la quantité de B) étant de 12 à 45% en poids par rapport à la composition totale.

3. Corps multicouche selon l'une quelconque des revendications 1 ou 2, la quantité de B) étant de 18 à 35% en poids par rapport à la composition totale.

4. Corps multicouche selon l'une quelconque des revendications 1 à 3, les quantités de B) et de C) étant adaptées l'une à l'autre avant le mélange de manière telle qu'on utilise, par 10 parties en poids du composant B), 0,25 à 1,4 partie du composant C).

5. Corps multicouche selon l'une quelconque des revendications 1 à 4, le talc ou le mélange de talc du composant B) présentant une valeur de pH de 8 à 10, la valeur de pH du talc ou du mélange de talc étant déterminée selon la norme EN ISO 787-9:1995.

6. Corps multicouche selon l'une quelconque des revendications 1 à 5, le composant B) présentant un diamètre moyen de particule D50 de 0,5 à 3,0 µm, le diamètre moyen de particule étant déterminé par analyse par sédimentation.

7. Corps multicouche selon l'une quelconque des revendications 1 à 6, le composant B) présentant une surface BET de 7,5 à 20,0 m²/g.

8. Corps multicouche selon l'une quelconque des revendications 1 à 7, la couche de substrat présentant une épaisseur de 0,1 mm à 6,0 mm, la couche métallique présentant une épaisseur de 10 nm à 1000 nm et la couche de protection éventuelle présentant une épaisseur de 5 nm à 200 nm.

9. Corps multicouche selon l'une quelconque des revendications 1 à 8, la couche métallique comprenant au moins un métal, qui est choisi dans le groupe constitué par l'aluminium, l'argent, le chrome, le titane et le palladium.

10. Corps multicouche selon l'une quelconque des revendications 1 à 9, la couche métallique comprenant de l'argent ou de l'aluminium.

11. Corps multicouche selon l'une quelconque des revendications 1 à 10, ou, dans le cas où du graphite est présent en tant que composant D), 2 à 7 parties en poids de la quantité du composant B) sont remplacées et où, dans le cas où du nitrure de bore est présent comme composant D), 2 à 12 parties en poids de la quantité de composant B) sont remplacées.

12. Réflecteurs ainsi que pièces de sources de lumière et de chaleur, comprenant le corps multicouche selon l'une quelconque des revendications 1 à 11.

13. Procédé pour la fabrication d'un corps multicouche selon l'une quelconque des revendications 1 à 11, comprenant les étapes
(a) formation de la couche de substrat par moulage par injection ou extrusion de la composition, contenant au moins les composants A) à C), contenant éventuellement le composant D),
(b) application de la couche métallique sur la couche obtenue dans l'étape (a) dans un procédé au plasma et
(c) le cas échéant application d'au moins une autre couche ainsi que
(d) le cas échéant application de la couche de protection sur la couche obtenue dans l'étape (b) ou (c).

14. Utilisation d'au moins un polymère alpha-oléfinique modifié par anhydride C) présentant un indice d'acide d'au moins 30 mg de KOH/g et un poids moléculaire moyen MW de 4000 à 25.000 g/mole, le poids moléculaire moyen MW étant déterminé par chromatographie par perméation de gel dans de l'ortho-dichlorobenzène à 150°C avec un étalonnage au polystyrène pour la fabrication d'une couche de substrat d'un corps multicouche, le corps multicouche comprenant au moins ladite une couche de substrat, une couche métallique directement reliée à celle-ci et le cas échéant au moins une couche appliquée sur la couche métallique et la couche de substrat comprenant une composition qui est obtenue par mélange au moins des composants A) à D),
A) étant un polycarbonate et
B) étant un talc non revêtu,
ainsi que, éventuellement, D) une partie de la quantité de composants B) pouvant être remplacée, comme autre charge, par au moins une autre charge choisie dans le groupe constitué par
a) un graphite expansé présentant un diamètre de particule D50 inférieur à 800 µm,
b) un mélange du graphite expansé susmentionné avec du graphite non expansé,
c) un mélange du graphite expansé susmentionné avec du graphite non expansé et du nitrure de bore,
d) un mélange du graphite expansé susmentionné avec du nitrure de bore ou.

15. Utilisation selon la revendication 14, les quantités de B) et de C) étant adaptées l'une à l'autre avant le mélange de manière telle qu'on utilise, par 10 parties en poids du composant B), 0,25 à 1,4 partie du composant C) .
